Europäisches Patentamt

European Patent Office

Office européen des brevets

(19)

(11) EP 0 439 327 B1

(12) **EUROPEAN PATENT SPECIFICATION**

(45) Date of publication and mention
of the grant of the patent:
**27.03.1996 Bulletin 1996/13**

(51) Int Cl.⁶: **H01L 41/04**

(21) Application number: **91300474.3**

(22) Date of filing: **22.01.1991**

(54) **A system and method for controlling a micro-pump**

System und Verfahren zur Regelung einer Micropumpe

Système et méthode pour le contrôle d'une micropompe

(84) Designated Contracting States:
**CH DE FR GB LI NL**

(30) Priority: **23.01.1990 JP 11843/90**
**31.01.1990 JP 19243/90**
**29.06.1990 JP 170285/90**
**29.06.1990 JP 170286/90**

(43) Date of publication of application:
**31.07.1991 Bulletin 1991/31**

(73) Proprietor: **SEIKO EPSON CORPORATION**
**Shinjuku-ku Tokyo (JP)**

(72) Inventors:
• **Miyazaki, Hajime, c/o Seiko Epson Corporation**
**Suwa-shi, Nagano-ken (JP)**

• **Handa, Masaaki, c/o Seiko Epson Corporation**
**Suwa-shi, Nagano-ken (JP)**
• **Uehara, Taisuke, c/o Seiko Epson Corporation**
**Suwa-shi, Nagano-ken (JP)**
• **Muranaka, Tsukasa,**
**c/o Seiko Epson Corporation**
**Suwa-shi, Nagano-ken (JP)**

(74) Representative: **Sturt, Clifford Mark et al**
**J. MILLER & CO.**
**34 Bedford Row,**
**Holborn**
**London WC1R 4JH (GB)**

(56) References cited:
**US-A- 4 649 886**

• **PATENT ABSTRACTS OF JAPAN vol. 14, no.**
**331 (M-999) 17 July 1990 & JP-A-2112678**

## Description

The present invention relates to a liquid medicine injection apparatus. US-A-4649886 relates to a fuel injection system for an internal combustion engine which utilises a piezoelectric actuator for a fuel injection device. However this device does not provide the degree of control and accuracy of injection of tiny quantities of liquid required by a liquid medicine injection apparatus.

A two valve type of micro-pump for a liquid medicine injection apparatus is disclosed in "Nikkei Electronics" No. 480, published on August 21st, 1989, in pages 135 to 139 of a special feature included in the publication on Si micro machining techniques. The disclosure suggests that this micro-pump is capable of precise flow control of trace amounts and therefore that it can be used in medical applications, e.g. in the medication of insulin for a diabetic, and in chemical analysis and such like.

However, where such a micro-pump is intended for use in a liquid medicine injection apparatus, its safety features present very significant problems and as yet a liquid medicine injection apparatus, in which adequate control of the discharge rate and adequate safety measures are ensured, has not been provided.

It is therefore, an object of the present invention to provide a liquid medicine injection apparatus which is capable of accurately controlling the rate of flow of trace amounts to be delivered by a micro-pump.

According to one aspect of the present invention, there is provided a liquid medicine injection apparatus including control system for a micro-pump, the control system comprising means for generating driving pulses for application to a piezo-electric element for driving the pump, and characterised by means for controlling the discharge of fluid by the pump by selectively controlling the generation of the driving pulses, the control means comprising setting means responsive to input driving pulse data for setting a value for a given characteristic of the driving pulses generated in a predetermined driving period, and level selection means responsive to a switch input for selecting between fractional quantities of the set characteristic whereby to provide precise control of the discharge rate of the pump.

Preferably, the control system is so designed that the number of pulses of a given frequency generated within a given period is controlled in accordance with the desired unit discharge rate of the micro-pump for controlling the discharge rate. Thus, by controlling the discharge rate digitally, it is possible to obtain a control characteristic that enables the discharge of trace amounts to be controlled with a high degree of accuracy. Further, suitable control circuitry may easily be provided by a custom made LSI thereby providing a product, which is small in size, light in weight and low in cost.

In an alternative embodiment, the control system is so designed that the driving pulse frequency is controlled in accordance with the desired unit discharge rate of the micro-pump for controlling the discharge rate. In this way, the discharge rate may be controlled to attain a constant value with respect to time, which has the advantage of greatly reducing ripple in the discharge rate.

Alternatively, or in addition, the control system may be so designed that the driving pulse voltage is controlled in accordance with the desired unit discharge rate of the micro-pump for controlling the discharge rate. In this way, analog control of the discharge rate is provided, and hence more accurate and finer control is possible.

In a preferred embodiment the control system includes a timer for measuring the period of time worked even if the operation of the micro-pump is stopped. Then, the product life of the fluid to be supplied is controlled by the timer and a life prediction warning may be supplied at a given time before expiry of the product life and a life expiration warning may be given on expiry of the product life.

According to this preferred embodiment of the present invention, the liquid medicine injection apparatus further includes means for monitoring the remaining product life of the fluid, the monitoring means comprising a timer arranged to start counting to a pre-set value upon receipt of a start signal, means for re-setting the timer to an intermediate value upon actuation of a switch, the intermediate value comprising the pre-set value minus an integer quantity representing the time that has passed following receipt of the start signal, and means for generating a warning in response to the timer reaching the pre-set value to signify that the remaining product life of the fluid is approaching and/or has reached expiry.

In accordance with a further preferred embodiment of the present invention, potential variations of the piezo-electric element for driving the micro-pump are detected to monitor the operating condition of the micro-pump and to trigger an alarm when a fault exists in order to inform the user.

In accordance with this preferred embodiment the liquid medicine injection apparatus is characterised by means for controlling the discharge of fluid by the pump, the control means comprising means for monitoring a detection potential at a terminal for supplying the driving pulses to the piezo-electric element, the monitoring means comprising means for sampling the detection potential at pre-determined times in a driving period, means for comparing the sampled detection potential with a reference, and means for generating a warning in response to an output from the comparing means.

In accordance with a still further preferred embodiment, the control system includes a watchdog timer for monitoring clock signals employed in the control system and for generating a warning when the frequency of the clock signals is either lower or higher than normal.

In accordance with this preferred embodiment, the watch-dog timer may comprise a first clock oscillation circuit for generating a first oscillation frequency $f_1$, a second clock oscillation circuit for generating a second oscillation frequency $f_2$, a first frequency divider circuit for subjecting the oscillation frequency $f_1$ to $1/N_1$ frequency division, a second frequency divider circuit for subjecting the first oscillation frequency $f_1$ to $1/N_2$ frequency division, a third frequency divider circuit for subjecting the second oscillation frequency $f_2$ to $1/N_3$ frequency division, and a fourth frequency divider circuit for subjecting the second oscillation frequency $f_2$ to $1/N_4$ frequency division. The watch-dog timer further includes a scale of $N_5$ counter for receiving the signal of the output frequency $f_1/N_1$ of the first frequency divider circuit as a clock input and the signal of the output frequency $f_2/N_3$ of the third frequency divider circuit as a re-set input with $f_1/N_1 N_5 < f_2/N_3$ in the normal condition, a scale of $N_6$ counter for receiving the signal of the output frequency $F_2/N_4$ of the fourth frequency divider circuit as a clock input and the signal of the frequency $f_1/N_2$ as a re-set input with $f_2/N_4 N_6 < f_1/N_2$, and a discrimination circuit for determining the presence of a fault in accordance with an output of the scale of $N_5$ counter and/or of the scale of $N_6$ counter.

The third frequency divider circuit may concurrently function also as the fourth frequency divider circuit.

Preferably, the watch-dog timer further includes a counter check circuit for detecting a change between the outputs of one of a plurality of flip flop circuits forming the scale of $N_5$ counter or the scale of $N_6$ counter before and after the application of a re-set signal to the flip flop circuits.

Conveniently, the counter check circuit may include a D type flip flop circuit for receiving as a clock signal a signal in phase with the re-set signal applied to the flip flop circuits of the scale of $N_5$ counter or the scale of $N_6$ counter and an output of said one flip flop circuit at its data terminal, a NAND gate circuit for receiving the output of the D type flip flop circuit and the inverted output from said one flip flop circuit, and another D type flip flop circuit for receiving the output of the NAND gate circuit at its data terminal and the re-set signal at its clock terminal.

When a fault occurs in either of the first and second oscillation circuits or any of the first to fourth frequency divider circuits so that the corresponding output frequency becomes higher or lower than a given value, the fault is detected by the scale of $N_5$ counter or the scale of $N_6$ counter. Alternatively, when a fault occurs in the operation of one of the counters itself, the counter check circuit detects and indicates the fault.

In accordance with yet another preferred embodiment of the present invention, the control system includes a soft start circuit for a switching regulator, which is free of frequency variations and capable of suitably selecting its frequency.

In accordance with this embodiment the soft start circuit includes a timer responsive to the application of a start signal to generate an initial condition release signal after the expiration of a given time period, a frequency divider circuit for dividing an oscillation frequency, a gate control circuit for receiving the output signal of the frequency divider circuit and the initial condition release signal whereby a gate control signal of a frequency dependent on the output signal of the frequency divider circuit is generated when the initial condition release signal is off and a gate control signal for delivering all of the input signals is generated when the initial condition release signal is on, and a gate circuit for receiving the oscillation frequency signals and the gate control signal and for supplying output signals.

Preferably, the frequency divider circuit of the soft start circuit divides the oscillation frequency in multiple steps to supply a plurality of frequency divided outputs, and the gate control circuit receives the plurality of frequency divided outputs from the frequency divider circuit, the initial condition release signal and a first control signal and supplies a gate control signal formed by combining the plurality of frequency divided outputs in accordance with the first control signal when the initial condition release signal is off and a gate control signal for enabling the transmission of all the input signals when the initial condition release signal is on.

Conveniently, the switching regulator of the soft start circuit comprises, in place of the above mentioned gate control circuit, a gate control circuit for receiving the plurality of frequency divided outputs from the frequency divider circuit, the initial condition release signal, the first control signal and a second control signal and supplies to the gate circuit a first gate control signal formed by combining the plurality of frequency divided outputs according to the first control signal when the initial condition release signal is off and a second gate control signal formed by combining the plurality of frequency divided outputs according to the second control signal when the initial condition release signal is on, the frequency of the second gate control signal being higher than the frequency of the first gate control signal.

With the above mentioned switching regulator, in the initial condition, the gate circuit delivers the output signals based on the frequency divided outputs of the frequency divider circuit in accordance with the then current gate control signal. Also, in a steady state condition following the initial condition, the gate circuit generates the signals of the oscillation frequency or the output signals of a frequency higher than that in the initial condition.

In accordance with a still further preferred embodiment of the present invention. there is provided a supervisory control method for demonstrating various functions of the micro-pump for demonstration purposes and for checking safety measures.

According to this embodiment of the present invention, there is provided a micro-pump supervisory control method capable of performing at least one of a discharge demonstration for driving the micro-pump for a given period of time to deliver a liquid, an alarm demonstration for giving life prediction and life expiration warnings and an operation acknowledge sound demonstration for giving an alarm on a given sounding pattern.

The invention will be described further, by way of example, with reference to the accompanying drawings, in which:-

Figure 1 is a block diagram of liquid medicine injection apparatus employing a micro-pump and a control system according to a first embodiment of the present invention;

Figure 2 is a circuit diagram showing details of the control system of Figure 1;

Figure 3 is a diagram for explaining the functions of switches in the control system of Figure 2;

Figure 4 is a diagram for explaining the operating conditions of the control system of Figure 2;

Figures 5 and 6 are timing charts showing different sound signal wave forms for function acknowledgement purposes in the control system of Figure 2;

Figure 7 is a diagram showing the display on a display unit of the control system of Figure 2 during the period of a discharge demonstration;

Figure 8 is a diagram showing the displays on the display unit during the period of an alarm demonstration;

Figure 9 is a diagram showing the display on the display unit during the period of an operation acknowledge demonstration;

Figure 10 is a timing chart showing the sound signal wave form for the operation acknowledge function;

Figure 11 is a timing chart showing a discharge frequency and its cycle;

Figure 12 is a diagram for explaining a timer setting operation;

Figure 13 is a timing chart showing a sound signal wave form for a life prediction warning;

Figure 14 is a timing chart showing a sound signal wave form for a life expiration warning;

Figure 15 is a characteristic diagram showing the relation between the potential variation at a terminal of a control circuit of the control system of Figure 2 and the lapsed time from a leading edge of a piezo-electric driving pulse;

Figure 16 is a sectional view showing an embodiment of a micro-pump arranged to be pulse driven by a piezo-electric element according to the present invention;

Figure 17 is a block diagram of a driving circuit for driving the micro-pump by means of the piezo-electic element;

Figures 18A and 18B are diagrams showing the micro-pump of Figure 16 in different operating states;

Figure 19 is a block diagram of liquid medicine injection apparatus employing the micro-pump of Figure 16 and a further control system according to the present invention;

Figure 20 is a block diagram showing a first form of control means of the control system of Figure 19;

Figure 21 is a wave form diagram for explaining the operation of the control means of Figure 20;

Figure 22 is a block diagram showing a second form of the control means of the control system of Figure 19;

Figure 23 is a wave form diagram for explaining the operation of the control means of Figure 22;

Figure 24 is a block diagram showing another form of the control means of the control system of Figure 19;

Figure 25 is a wave form diagram for explaining the operation of the control means of Figure 24;

Figure 26 is a block diagram of a watch-dog timer of the control system of Figure 19;

Figure 27 is a circuit diagram showing details of the watch-dog timer of Figure 26;

Figures 28, 29 and 30 are timing charts showing signal wave forms of the watch-dog timer of Figure 26;

Figures 31 and 32 are block diagrams of another watch-dog timer;

Figures 33 and 34 are timing charts showing respectively signal wave forms of the portions of the watch-dog timer illustrated in Figures 31 and 32;

Figure 35 is a circuit diagram of a soft start circuit for a switching regulator of the control system of Figure 19; and

Figures 36 to 38 are timing charts showing signal wave forms of the soft start circuit of Figure 35.

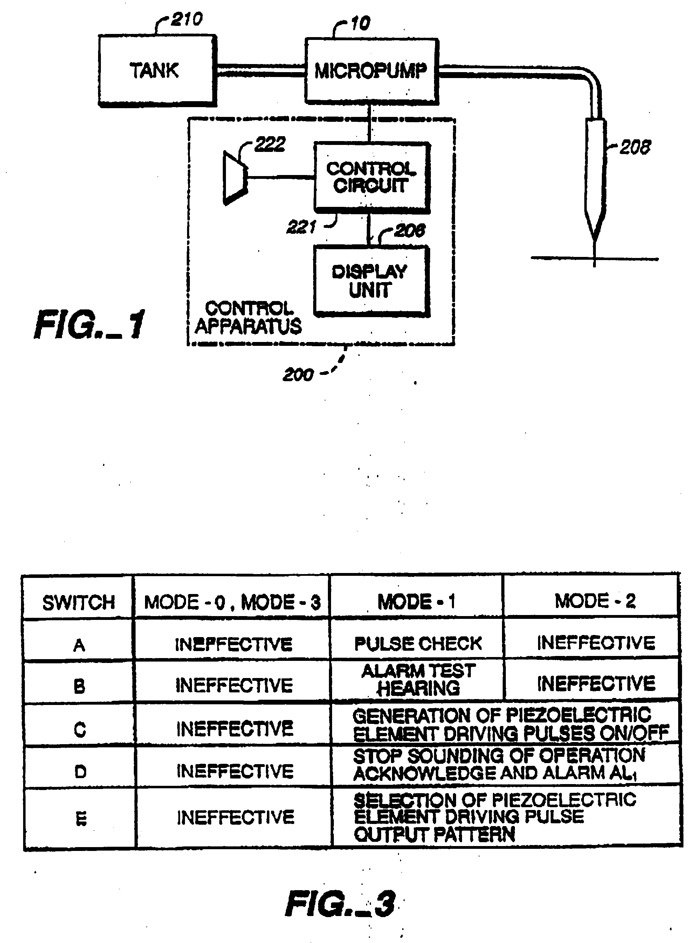

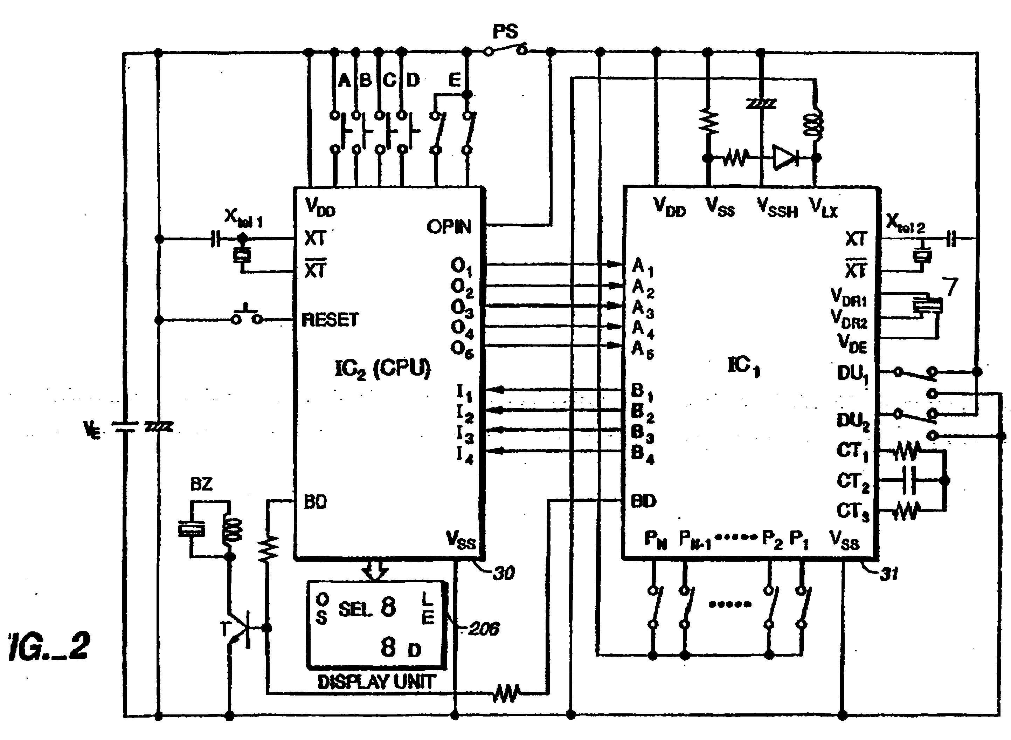

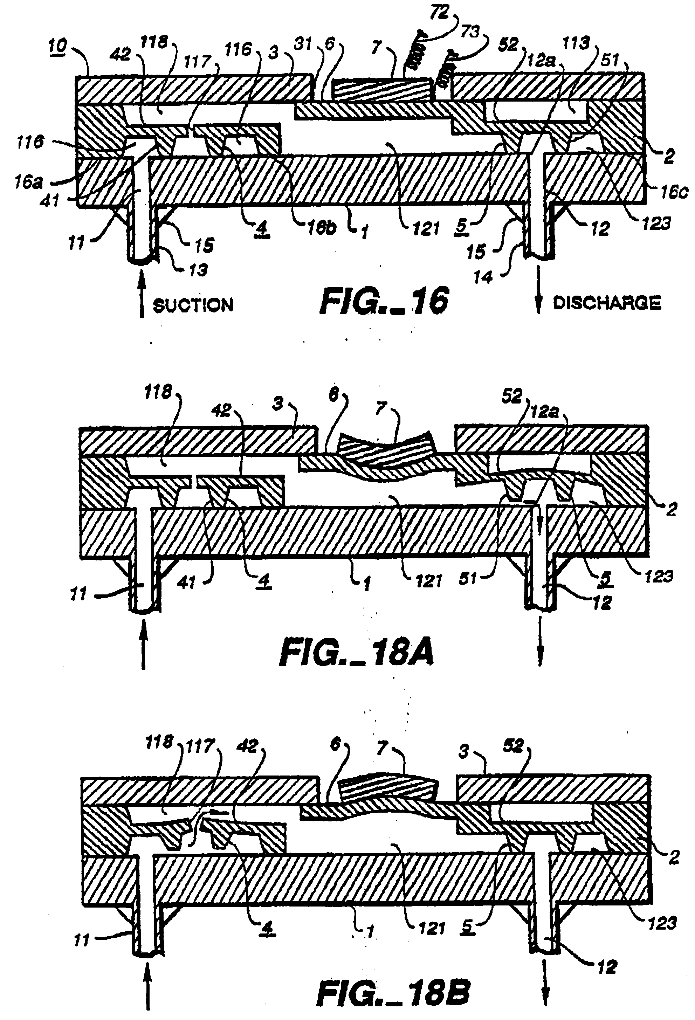

Figure 1 is a block diagram showing liquid medicine injection apparatus employing a micro-pump and a micro-pump supervisory control system according to the present invention. A tank 210 containing liquid medicine for injection is connected to a micro-pump 10. As will be seen from its construction, which is shown in Figures 16 etc. and which will be described later, the micro-pump 10 is designed so that a voltage applied to a piezo-electric element incorporated therein causes a strain and the strain force is utilised as a pump force. Thus, the micro-pump is suitable for delivering trace amounts of liquid medicine or the like over a long period of time. A needle of a syringe 208 injects into the body the liquid drawn from the tank 210 by the micro-pump 10. A control system 200 for controlling the micro-pump 10 comprises a control circuit 221, an alarm 222 and a display unit 206.

Figure 2 is a circuit diagram showing details of the control system 200, which performs various control functions. The control system 200 includes the control circuit 221, comprising a first integrated circuit 31, and a second integrated circuit 30 in the form of a CPU, and forms a driver for a piezo-electric element 7. It is to be noted that the piezo-electric element 7 in Figure 2 is contained in the micro-pump 10, driving pulses from the control circuit 221 being applied to the piezo-electric element 7 for driving the micro-pump 10.

Figure 3 is an explanatory diagram showing the functions of a plurality of switches A to D and a selection switch E, which are connected to the CPU 30, and showing various modes set by these switches.

It is assumed here that "mode 0" to "mode 3" respectively represent the following conditions:

Mode 0: A time interval from re-setting the system up to the detection of a signal change from a level L to a level H at an OPIN terminal of the CPU 30 (the OPIN terminal always reads in at 32 Hz after the system re-setting).

Mode 1: A time interval from mode 0 until the switch C is closed.

Mode 2: A time interval from mode 1 until the generation of a life expiration warning $AL_2$.

Mode 3: A time interval from mode 2 on i.e. from the generation of the life expiration warning $AL_2$ on.

In addition to the switches A to E, there is provided a power supply switch PS having the following functions:

1.    Effecting transition from mode 0 to mode 1, i.e. transition of the OPIN terminal from the level L to the level H.

2.    Disabling mode 1 to mode 3, i.e. effecting transition of the OPIN terminal from the level H to the level L.

It is to be noted that the second IC 30 and the first IC 31 perform processing such that when the power supply switch PS is changed from the ON state to the OFF state, the apparatus is prevented from functioning even if the power supply switch PS is turned on again.

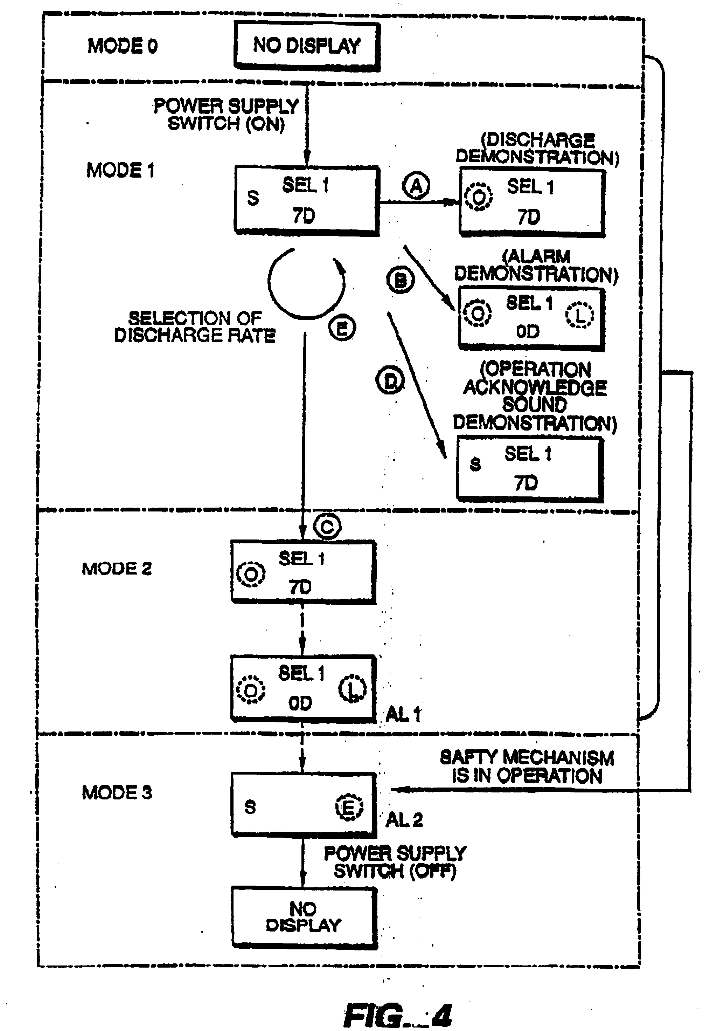

Figure 4 is a diagram showing the operating conditions of the control system 200. Mode 0 to mode 3 are illustrated in this order and will be described in detail below in connection with certain associated operations:

(a) Various function acknowledge signals, comprising sound signals produced by a buzzer BZ, will be described first:

When the L - H transition of the OPIN terminal is detected, after the system has been re-set, the second IC 30 causes the buzzer BZ to produce a sound signal. Also, when the switch A is closed to initiate a medicine discharge demonstration 9, driving pulses are generated so that the micro-pump 10 is driven to discharge a given amount of the medicine and a sound signal is produced upon completion of such discharge. Also, a sound signal is produced when the switch B is closed to initiate an alarm demonstration, as well as when the switch E is changed over by switching two contacts thereof.

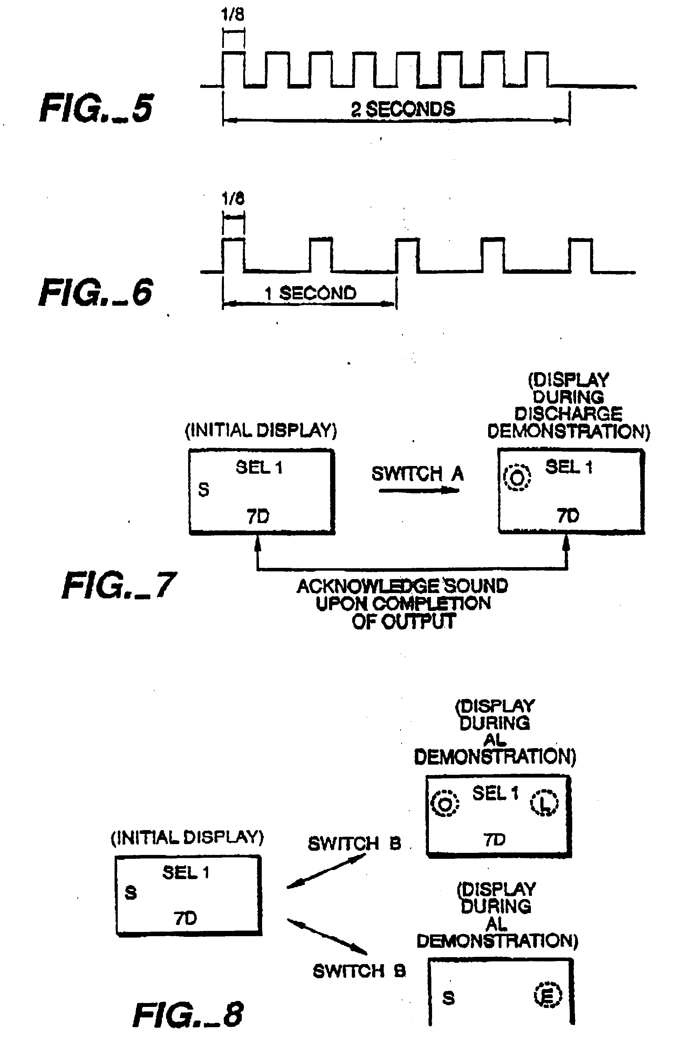

Figure 5 is a timing chart showing an example of a sound signal wave form in such cases, the sound signal being produced as a driving frequency of 4096 Hz for two seconds.

Also, as will be described later, a sound signal is continuously produced during the time that the switch D is closed in order to perform an operation acknowledge demonstration. Figure 6 is a timing chart showing by way of example the sound signal produced in such a case.

(b) The various demonstrations will now be described:

(b-1) The medicine discharge demonstration:

The medicine discharge demonstration constitutes a discharge operation performed at a pre-set discharge rate and is effected by the closing of the switch A. In this demonstration, driving pulses are applied to the piezo-electric element 7 for a single driving period to drive the micro-pump 10 at the pre-set discharge rate.

Figure 7 is a schematic diagram showing the display on the display unit in such a case. The initial display is as shown on the left side of the Figure, and the display in the course of the discharge demonstration becomes as shown on the right side of the Figure. The initial display condition is restored upon the completion of the discharge demonstration.

The driving pulses for this demonstration consist of a pre-determined number of pulses having a frequency of 1 Hz so that the piezo-electric element 7 is operated only during this time period for driving the micro-pump 10 whereby the injection liquid in the tank 210 is delivered through the needle of the syringe 208. When this operation is completed, a sound signal is produced having the wave form shown in Figure 5 as mentioned previously.

(b-2) The alarm demonstration:

In response to the closing of the switch B, life prediction warning ($AL_1$) and life expiration warning ($AL_2$) demonstrations are effected. During the time that the switch B is closed, an alarm is sounded and simultaneously the display is replaced by an alarm display.

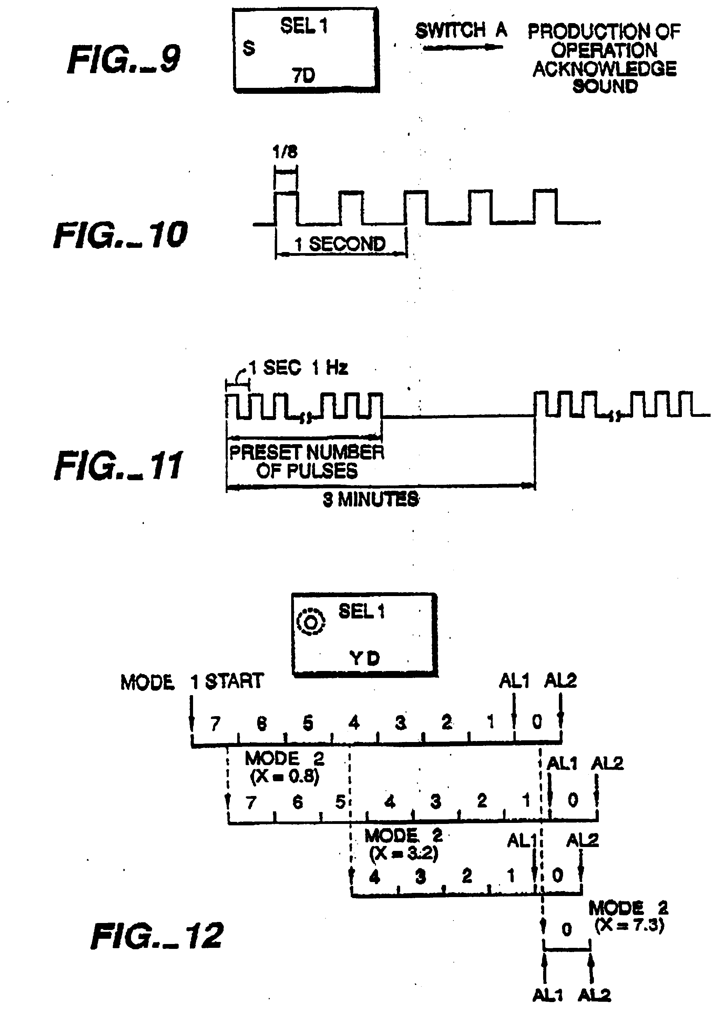

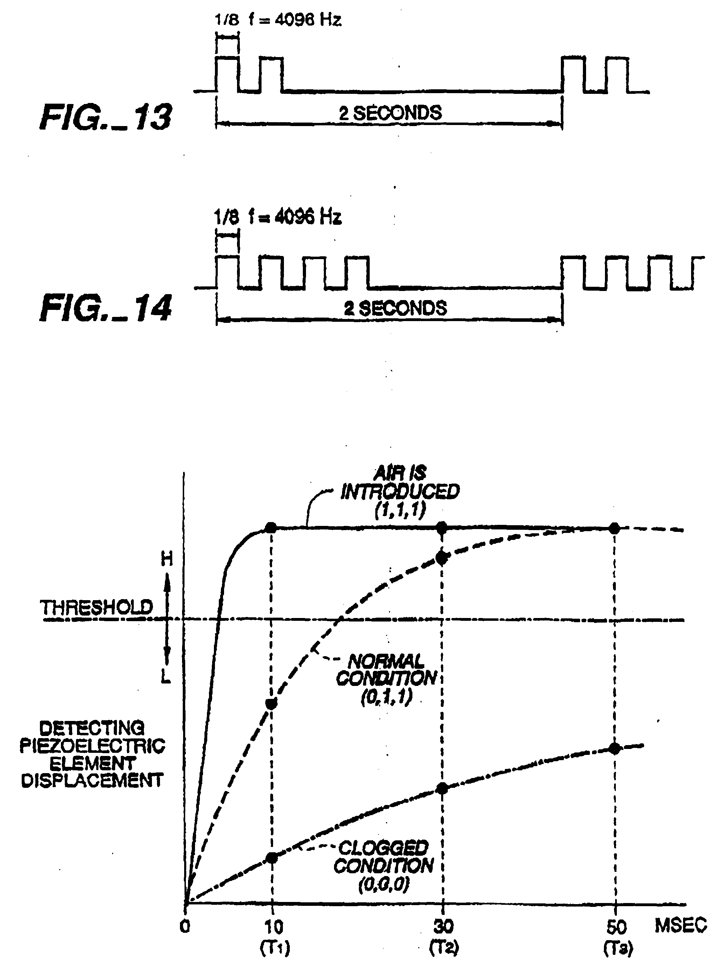

Figure 8 is a schematic diagram showing the displays on the display unit in such a case. Each time that the switch B is closed, the sound signal and the display (L or E) for each of the life prediction warning ($AL_1$) and the life expiration warning ($AL_2$) are produced cyclically. In this case, the sound signal wave forms are, respectively, the same as those shown in Figures 13 and 14, which will be described later.

(b-3) The operation acknowledge demonstration:

When the switch D is closed, the operation acknowledge demonstration for determining whether the apparatus is operating properly is effected. When the apparatus is functioning properly, an operation acknowledge sound signal is produced thereby signalling that the operation is normal. The operation acknowledge sound signal is produced for so long as the switch D is closed.

Figure 9 is a schematic diagram showing the display in such a case, which remains the same as in the initial condition. At this time, the resulting sound signal wave form is as shown in Figure 6.

(c) The operation acknowledge function will now be described:

When the apparatus is operating properly in mode 2 (including both the case where the discharge condition exists and the case where the discharge is stopped), the closing of the switch D produces a sound signal to indicate that the apparatus is operating properly. Determination as to whether the operation is correct or not is effected by determining whether the operation is passing through a proper software processing loop of the second IC 30 and the first IC 31.

Figure 10 is a timing chart of the sound signal wave form for the operation acknowledge function in such a case. During the time that the switch D is closed, a sound signal is continuously produced at a frequency of 4096 Hz. It is to be noted that the display during this period is the same as the display during operation.

(d) The setting of a discharge rate will now be described:

Firstly, the setting of a discharge rate is effected in the following manner: Driving pulse data is input to the first IC 31 in the form of data bits $P_n$ to $P_1$ and basic driving pulses P are set in accordance with the following equation:

$$P = 10 + (P_8, P_7, P_6, P_5, P_4)$$

For instance, if there are inputs $P_8$ and $P_4$, the following results:
$$P = 10 + (1, 0, 0, 0, 1) = 27 \text{ pulses}$$
Here, $(P_3, P_2, P_1)$ are correction bits. For instance, the following hold:
$$(1, 0, 1) = -3$$
$$(1, 1, 0) = -2$$
$$(1, 1, 1) = -1$$
$$(0, 0, 0) = 0$$
$$(0, 0, 1) = +1$$
$$(0, 1, 0) = +2$$
$$(0, 1, 1) = +3$$
$$(1, 0, 0) = +4$$
An actual number of driving pulses PR, including the correction bits, is represented by the following equation:

$$PR = 10 + (P_8, P_7, P_6, P_5, P_4, P_3, P_2, P_1)$$

For instance, an example is as follows:
$$PR = 10 + (1, 0, 0, 0, 1, 0, 1, 1) = 30$$
The discharge rate is adjusted by using the two contacts of the switch E so that three states, namely (0, 0), (0, 1) and (1, 0), are produced whereby the discharge rate may be selectively adjusted to three levels LO, MI and HI. The levels LO, MI and HI are respectively given by the following equations. (In practice, the decimal following the decimal point are omitted).
$$LO : PRL = PR$$
$$MI : PRM = PR \times 11/8$$
$$HI : PRH = PR \times 7/4$$
Figure 11 is a timing chart showing the discharge frequency and its cycle. In this case, a pre-set number of pulses are arranged in the first half of a given period, three minutes for example. Of course, the pre-set number of pulses may be uniformly distributed within the period of three minutes. It is to be noted that when the selection of the level LO, MI or HI is made, the resulting display on the display unit 23 becomes "SEL1", "SEL2" or "SEL3", respectively.

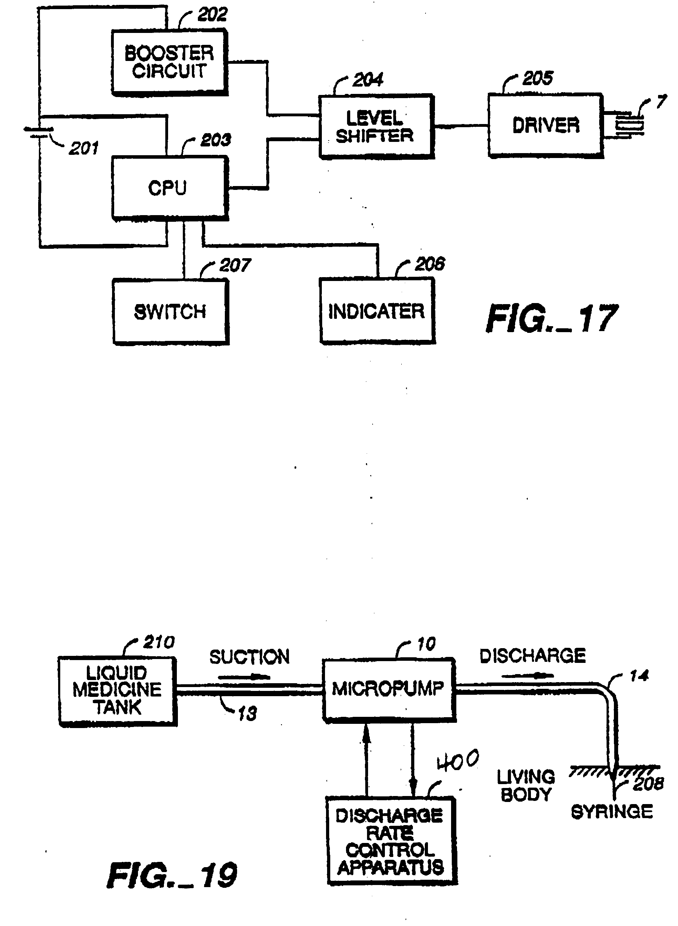

The control of the discharge rate will be described in greater detail with reference to Figure 19 and the following:

(e) A timer function of the control system for determining the product life will now be described:

The description will be made on the assumption that the product or time for the liquid to run out of the micro-pump 10 in the control system 200 is eight days, as determined by an eight day timer.

The setting of the timer is effected in the following manner. For instance, when the apparatus is placed in mode 2 after $\underline{x}$ days since the time when it was placed in mode 1, the eight day timer is re-set to $(8 - INT (x))$ days and the timer is started anew. It is to be noted that $INT (x)$ indicates the integer form of $\underline{x}$ and therefore $INT (1.5) = 1$ for example.

Figure 12 is a diagram for explaining the operation in such a case. For instance, if mode 2 is started 0.8 days after mode 1 was started, the timer is re-started at $(8 - INT (x))$ days, being eight days in this instance. At this time, the display becomes $y = 7 - INT (x)$ days $(0 < x < 8)$. When the number of days left becomes one, the life prediction warning $AL_1$ is sounded, and when the number of remaining days is reduced to zero, the life expiration warning $AL_2$ is sounded. In this example, the elapse of eight days following the start of mode 2 is required for the sounding of the life expiration warning $AL_2$.

If, for example, mode 2 is started 3.2 days after mode 1 has been started, the timer is re-started at $(8 - INT (x))$ days, being five days. At this time, the display is in the form $y = 7 - INT (3.2) =$ four days. As before, the life prediction warning $AL_1$ is sounded when the number of remaining days is reduced to one and the life expiration warning $AL_2$ is sounded when the number of remaining days is reduced to zero. In this example, the lapse of five days since the starting of mode 2 is required for the sounding of the life expiration warning $AL_2$.

On the other hand, if for example mode 2 is started 7.3 days after mode 1 has been started, the timer is re-started at $(8 - INT (x))$ days, being one day. At this time, the display indicates $y = 7 - INT (7.3) = 0$ days. Then, since the number of remaining days is one, the life prediction warning $AL_1$ is immediately sounded, the life expiration warning then being sounded when the number of remaining days is reduced to zero. In this example, the lapse of one day after the start of mode 2 is required before the life expiration warning $AL_2$ is sounded.

Note that where $x > 8$, the life expiration warning $AL_2$ is sounded immediately and the apparatus cannot be placed in mode 2.

(e-1) The life prediction warning $AL_1$ will now be explained:

The life prediction warning $AL_1$ is effected by the production of a sound signal at the expiration of seven days after the apparatus has been placed and left in mode 1 or at the expiration of $7 - INT (x)$ days after the apparatus has been placed in mode 2.

Figure 13 is a timing chart showing the sound signal wave form in such a case. The wave form of this Figure is repeatedly generated for thirty seconds at a sounding period of thirty minutes, this repetition being continued for twenty four hours unless a stop command is issued.

In order to stop the sound signal, the switch D is closed and the sound signal within the current sounding period is stopped. However, the sound signal is then produced upon reaching the next sounding period unless the switch D is again closed thereby stopping the sound signal again, whereafter no sound is produced even on reach succeeding sounding periods.

(e-2) The life expiration warning $AL_2$ will now be explained:

The life expiration warning $AL_2$ is effected by the production of a sound signal at the expiration of eight days after the system has been placed in mode 1 or at the expiration of $8 - INT (x)$ days after the time of placing the system in mode 2, as mentioned previously.

Figure 14 is a timing chart showing the sound signal wave form in such as case. The wave form in this Figure is repeated for thirty seconds at a period of thirty minutes in the absence of a stop command, the sound signal being produced continuously until the battery voltage drops thus terminating the operation of the second IC 30 or the first IC 31.

In order to stop the sound signal, the switch PS is opened. In other words, when the switch PS is opened, the OPIN terminal changes from the level H to the level L and the second IC 30 detects the change, being arranged to detect the level L by the second reading, and stops the sound signal. Once the sound signal is stopped by opening the switch PS, the sound signal is no longer produced.

It is to be noted that even if the discharge operation is stopped for safety purposes having regard to the life of a medicine, the timer continues its operation and thus the previously mentioned life prediction warning $AL_1$ and life expiration warning $AL_2$ are still given.

(f) The operation of the buzzer BZ of the control system will now be explained:

In this embodiment, the sounding of the buzzer BZ, or another alarm, may be effected by each of the second IC 30 and the first IC 31. In each of the described instances when the sound signal is produced, the sound signal is generated by turning on a transistor T shown in Figure 2 to drive the buzzer BZ. The buzzer BZ may be driven by each of the second IC 30 and the first IC 31 but with a shift in timing. As a result, even if one or other of the CPU 30 and the control circuit 31 malfunctions, the necessary information can still be supplied to the user.

(g) A safety mechanism for the control system will now be described:

The state of a terminal $V_{DE}$ connected to the piezo-electric element 7 is read at times $T_1$, $T_2$ and $T_3$ (seconds) from the leading edge of the first piezo-electric element driving pulse in each driving period (e.g. three minutes) of the driving pulses generated from a terminal $VDR_1$ shown in Figure 2, and is compared with a threshold value to generate values $(VT_1, VT_2, VT_3)$. In circumstances other than when the values $(VT_1, VT_2, VT_3) = (0, 1, 1)$, the state of the terminal $V_{DE}$ is read again in the next two periods and a sound signal having the same sound signal wave form of the life expiration warning $AL_2$ (hereinafter referred to as an alarm $AL_2$) is produced when the resulting values of each of the two reading operations are other than $(0, 1, 1)$.

Figure 15 is a characteristic diagram showing the relation between the potential variation at the terminal $V_{DE}$ and the time interval from the leading edge of the corresponding piezo-electric element driving pulse.

In the Figure, it is assumed that $T_1 = 10$ ms, $T_2 = 30$ ms and $T_3 = 50$ ms, and in the normal condition a comparison between the potentials at these time intervals and the threshold value shows that a result $(0, 1, 1)$ is obtained. However, when air is introduced into the micro-pump, the potential at the terminal $V_{DE}$ rises rapidly and a comparison between the resulting potentials and the threshold value results in $(1, 1, 1)$. In addition, when the needle point of the needle of the syringe 208 becomes clogged, the potential at the terminal $V_{DE}$ rises slowly so that a comparison between the resultant potentials and the threshold value results in $(0, 0, 0)$.

As described above, the potential variations of the piezo-electric element are detected to detect whether the micro-pump is operating properly or not and, when it is determined that the micro-pump is operating incorrectly, the switch PS is opened to stop the operation and enable the micro-pump to be replaced with another one.

On the other hand, the voltage of the battery VE is monitored at all times so that if the battery voltage, which is rated at 3 V, drops for example to 2.4 V to 2.5 V, this drop is detected and the alarm $AL_2$ is sounded. Also, if the system re-set is applied while the user is carrying the micro-pump (including cases where the re-set is caused by noise), the potential at the terminal OPIN is read to discriminate between the levels L and H and if the potential is at the level H, for example, the micro-pump is considered to be malfunctioning and the alarm $AL_2$ is triggered. In every case when the alarm $AL_2$ is triggered, the control system 200 stops the operation immediately thereby ensuring the safety of the user.

Needless to say, the above mentioned various demonstrations and sound signal wave forms are not limiting and can be modified appropriately as occasion demands.

An embodiment of a micro-pump adapted to be pulse driven by a piezo-electric element will now be described, and then the method of controlling the discharge rate of the micro-pump through the pulse driving of the piezo-electric element will be explained in detail.

Figure 16 is a sectional view showing an embodiment of the micro-pump 10 arranged to be pulse driven by the piezo-electric element 7 according to the present invention. The micro-pump 10 is composed of a sandwich structure including a base 1, a thin film sheet 2 and a surface sheet 3.

The base 1 comprises for example a glass plate having a thickness of about 1 mm and is formed with an inlet port 11 and an outlet port 12. Tubes 13 and 14 are respectively fitted over the ports 11 and 12 with an adhesive 15 to provide a fluid tight seal. The supply end of the tube 13 is connected for example to the liquid medicine tank 210 and the discharge end of the tube 14 is connected for example to the syringe 208.

The thin film sheet 2 comprises for example an Si substrate having a thickness of about 0.3 mm and is formed by an etching process with an inlet valve 4, an outlet valve 5, a diaphragm 6 interposed between the valves and the necessary flow passages (not shown). The thin film sheet 2 is bonded to the base 1 by an anodic bonding process, the bonding locations being indicated by numerals 16a, 16b and 16c.

The inlet port 11 is connected to an input passage (not shown) which communicates with a chamber 116 of the inlet valve 4 through a through hole and a communication passage (not shown) and communicates via a through hole (not shown) with a chamber 113 disposed above the outlet valve 5. The inlet valve 4 is formed with a cup shaped valve member 41, which is provided with a through hole 117 in its central portion for communication with a chamber 118 disposed above the valve 4. The chamber 118 communicates through still another through hole and communication passage (not shown) with a pump chamber 121 below the diaphragm 6 leading into a chamber 123 of the outlet valve 5 through an output passage such that the liquid under pressure flows into the outlet valve 5. The outlet valve 5 is formed with a cup shaped valve member 51 which covers an outlet opening 12a leading into the outlet port 12.

The piezo-electric element 7, comprising a piezo-electric disk, is adhered to the diaphragm 6 through a thin film electrode for driving the diaphragm 6. In the Figure, the numerals 72 and 73 designate lead wires for applying a voltage to the piezo-electric element 7.

The surface sheet 3, composed of a glass plate similar to the base 1, is also bonded by the anodic bonding process to the thin film sheet 2 so as to form an insertion opening 31 for the piezo-electric element 7 and thereby establish the above mentioned pump flow system. The surface sheet 3 has a thickness of about 0.5 mm.

Figure 17 is a block diagram showing an embodiment of a driving circuit of a further control system, for driving the micro-pump by means of the piezo-electric element. The driving circuit comprises a power source 201, e.g. a lithium cell, a booster circuit 202, a micro-processor 203 (hereinafter referred to as a CPU), a level shifter 204 for converting a low voltage signal to a high voltage signal, a driver 205 for driving the piezo-electric element 7, an indicator 206 for indicating the flow rate of the pump, and a selector switch 207 for flow rate controlling purposes.

Figures 18A and 18B are diagrams showing the pump of Figure 16 in different states of operation. The normal operation of the micro-pump will now be described with reference to Figures 17, 18A and 18B.

The desired flow rate is selected first by the switch 207 and driving pulse signals generated by the CPU 203 (the CPU 30). The CPU 203 is generally activated by a signal voltage level of 3 V to 5 V and the piezo-electric element 7 is operated by a high voltage, e.g. 50 V. Thus, the voltage level of 3 V is increased to 50 V by the booster circuit 202 and the driving pulse signals from the CPU 203 are converted to high voltage pulse signals at a level of 50 V by the level shifter 204.

The driver 205 then applies voltage pulses at 50 V as periodic driving signals of about 1 to several Hz to the piezo-electric element 7 thereby causing strain vibrations due to the piezo-electric effect. When the diaphragm 6 is deformed downwards as shown in Figure 18A due to the piezo-electric effect, the pressure in the pump chamber 121 is increased and this pressure is simultaneously transmitted through the flow passages to the chambers 118 and 123 to increase their internal pressures. As a result of the increase in the internal pressure of the chamber 118, a partition wall 42 of the inlet valve 4 is forced downwards so that the valve member 41 of the inlet valve 4 is pressed against the base 1 and the inlet valve 4 is closed. Simultaneously, the increase in the internal pressure of the chamber 123 forces a partition wall 52 of the outlet valve 5 upwards so that the valve member 51 of the outlet valve 5 is separated from the base 1 and the outlet valve 5 is opened thereby discharging a fixed amount of the liquid under pressure to the outlet port 12.

By contrast, when the diaphragm 6 is deformed upwards as shown in Figure 18B, thereby decreasing the internal pressure of the pump chamber 121, the partition wall 52 is deformed downwards thus closing the outlet valve 5, and simultaneously the partition wall 42 is deformed upwards thus opening the inlet valve 4 and thereby sucking a fixed amount of the liquid from the chamber 116 communicating with the inlet port 11 through the through hole 117.

By causing the diaphragm 6 to vibrate through the piezo-electric element 7, the above mentioned suction and discharge are effected continuously. Further, an increase in the number of vibrations ensures that the pump has a reduced ripple in its flow. Moreover, since the outlet valve 5 is formed by the cup shaped valve member 51, which covers the outlet opening 12a to the outlet port 12, the direction of a lifting force applied to the partition wall 52 due to back pressure from the outlet port 12 (the opening force of the outlet valve 5) is the same as the direction of the lifting movement of the partition wall 52 due to the pressure in the pump chamber 121. Therefore, the back pressure acts in a direction tending to open the outlet valve 5. As a result, the liquid is discharged at substantially a fixed flow rate within the desired working range of the pump in appropriate balance between the back pressure and the combination of the resilient force of the outlet valve 5 and the downwards force acting on the partition wall 52, for example due to an external force, until the outlet valve 5 is completely opened.

In the micro-pump 10 according to the present embodiment, when single pulses of 50 V, for example, are applied to the piezo-electric element 7 of the micro-pump (this is referred to as single pulse driving or single step driving), the liquid is discharged at a flow rate of about 0.05 µl/step.

Figure 19 is a block diagram of liquid medicine injection apparatus employing the micro-pump, showing another exemplary control system according to the present invention. In the Figure, the tube 13 is arranged between the liquid medicine tank 210 and the inlet port 11 of the micro-pump, and the tube 14 is arranged between the outlet port 12 of the micro-pump and the syringe 208 for injecting the liquid medicine into a living body. A control system 400 includes the micro-pump driving circuit of Figure 17 as a part thereof.

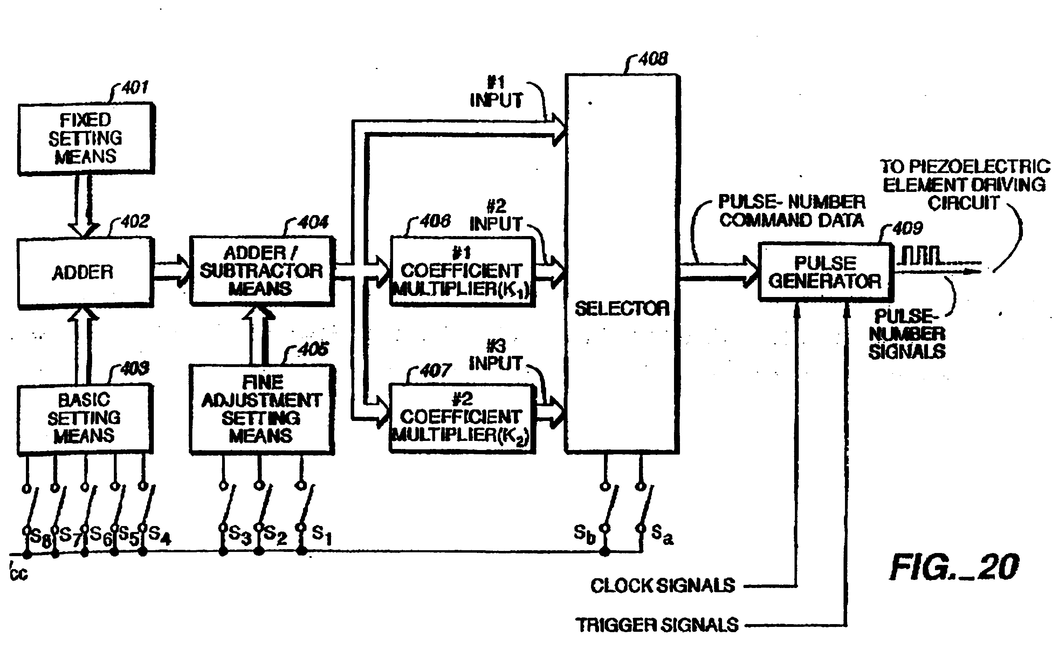

Specific embodiments of discharge rate control means of the system 400 will be described in detail in connection with Figures 20 to 25.

The control system employs various methods of control for the pulse driving of the micro-pump by the piezo-electric element for discharge rate control, which may broadly be divided into the following four types:

(1) Control of the driving pulse number.

(2) Control of the driving pulse frequency.

(3) Control of the piezo-electric element driving voltage.

(4) Control combining methods (1) or (2) and method (3) above.

The method of controlling the pulse number will be described first.

Figure 20 is a block diagram showing an embodiment of pulse number control means of the control system according to the present invention comprising fixed setting means 401, an adder 402, and basic setting means 403 capable of setting any given five bit binary number (0 to 31) through switches $S_8$ to $S_4$. The system further comprises adder/subtractor means 404, and fine adjustment setting means 405 capable of setting any one of the numbers ranging from -3 to +4 through the on and off operation of switches $S_3$ to $S_1$. A #1 co-efficient multiplier 406 receives input data and multiplies the same by, for example, a co-efficient $k_1 = 11/8$ to generate an output. A #2 co-efficient multiplier 407 receives the input data and multiplies the same by, for example a co-efficient $k_2 = 7/4$ to generate an output. A selector 408 receives the input data direct and by way of the co-efficient multipliers 406, 407 and selects one of the three sets of input data in accordance with outputs of switches $S_a$ and $S_b$. A pulse generator 409 is responsive to the application of a trigger signal to count clock signals and to thereby generate a pre-determined number of pulse signals. This circuit may be formed by a down counter, a flip flop, an AND gate or the like.

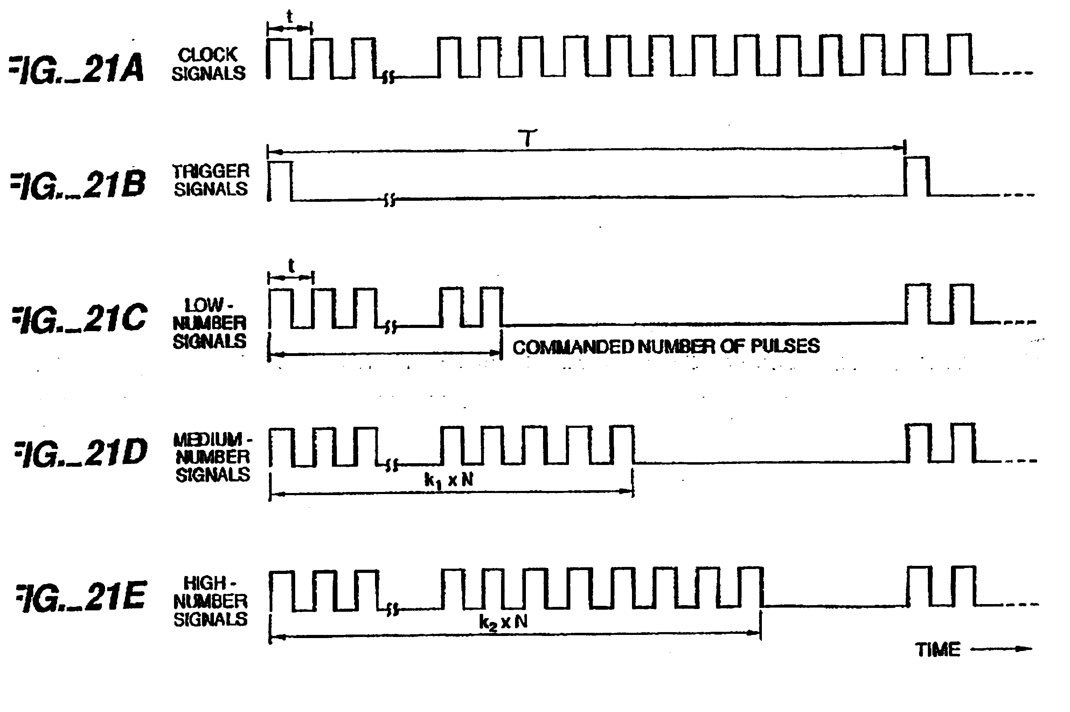

Figure 21 is a wave form diagram for explaining the operation of the circuitry of Figure 20.

The operation of the circuitry of Figure 20 will be described with reference to Figure 21. Assume now that a fixed number, 10, has been preliminarily set in the fixed setting means 401. Any given five bit binary number $\underline{n}$ (where $\underline{n}$ is a number between a minimum number 0 and a maximum number 31) is set in the basic setting means 403 through the on and off operation of the switches $S_8$ to $S_4$. The adder 402 adds the number 10 from the fixed setting means 401 and the number $\underline{n}$ from the basic setting means 403 to produce a number n + 10 which is between the minimum number 10 and the maximum number 41.

When the switches $S_3$ to $S_1$ are turned on, a corresponding input of the fine adjustment setting means 405 goes to a level "1" as a result of the application of a power supply voltage $V_{cc}$. When the switches $S_3$ to $S_1$ are turned off, the supply voltage $V_{cc}$ is not applied and the input of the fine adjustment setting means 405 goes to a level "0". Thus, depending on the setting of the switches $S_3$, $S_2$ and $S_1$, one of the following numerical values ranging from -3 to +4 is set:

$$S_3, \quad S_2, \quad S_1$$

| | | | | |
|---|---|---|---|---|
| 1, | 0, | 1 | = | -3 |
| 1, | 1, | 0 | = | -2 |
| 1, | 1, | 1 | = | -1 |
| 0, | 0, | 0 | = | -0 |
| 0, | 0, | 1 | = | 1 |
| 0, | 1, | 0 | = | 2 |
| 1, | 1, | 1 | = | 3 |
| 1, | 0, | 0 | = | 4 |

The adder/subtractor means 404 performs the operation of additional subtraction on the number n + 10 from the adder 402 and the fine adjustment number (the number between -3 and +4) and the result of the calculation is supplied directly as a #1 input signal to the selector 408 and is also supplied to the #1 co-efficient multiplier 406 and the #2 co-efficient multiplier 407. The #1 co-efficient multiplier 406 multiplies the input data by the co-efficient $k_1 = 11/8$, omits the fractions and supplies the resulting output data as a #2 input signal to the selector 408. The #2 co-efficient multiplier 407 multiplies the input data by the co-efficient $k_2 = 7/4$, similarly omits the fractions, and supplies the resulting output data as a # 3 input signal to the selector 408.

The selector 408 performs its selecting operation as shown below in accordance with the setting of the switches $S_a$ and $S_b$, and its output signal is supplied as a pulse number command to the pulse generator 409:

$$S_a, \quad S_b$$

| | | |
|---|---|---|
| 0, | 0 : | None of the input signals is output. |
| 0, | 1 : | The # 1 input signal is selected and output. |
| 1, | 0 : | The # 2 input signal is selected and output. |
| 1, | 1 : | The # 3 input signal is selected and output. |

Figure 21 (a) and Figure 21 (b) show respectively the wave forms of the clock signal and the trigger signal which are supplied to the pulse generator 409. The clock signal consists of repetitive pulses having a period $\underline{t}$ (e.g. one second) and having the same on and off times (e.g. the duty cycle is 50%). The trigger signal is a periodic signal having a period T, which is generated each time a given number of the clock pulses has been counted (e.g. if T is assumed to be the time required for counting 180 clock pulses having a frequency of 1 Hz, then T = 3 minutes).

When the pulse number command is supplied, the pulse generator 409 pre-sets the commanded pulse number in a counter (which may for example be incorporated therein). Then, when the trigger signal is applied, the generation of output pulses is immediately started and the number 1 is subtracted from the count for every output pulse. When the pre-set count is reduced to zero, the generation of the subsequent output pulses is inhibited. This operation is repeated in response to the application of each trigger signal. In this way, the commanded number of pulses are generated in response to the application of each trigger signal.

Figure 21 (c) shows the wave form for a low number of output pulses in the case when the #1 input signal from the adder/subtractor means 404 is selected by the selector 408, and Figure 21 (d) shows the wave form for a medium number of output pulses in the case when the #2 input signal from the #1 co-efficient multiplier 406 is selected by the selector 408. Figure 21 (e) shows the wave form for a high number of pulses in the case where the #3 input signal from the #2 co-efficient multiplier 407 is selected by the selector 408.

In the pulse number control means of Figure 20, a given number of pulses ranging from the minimum of 7 (= 10 + 0 - 3) to the maximum of 45 (= 10 + 31 + 4) in the case of a low number of pulses, from the minimum of 9 to the maximum of 61 in the case of a medium number of pulses, and from the minimum of 12 to the maximum of 72 in the case of a high number of pulses are generated within the period (three minutes in the previously mentioned case) of the trigger signal and these pulse signals are supplied to the level shifter 204 in the piezo-electric element driving circuit of Figure 17. The level shifter 204 converts the input pulse signals to high voltage pulse signals of 50 V, for example, thereby driving the piezo-electric element 7 through the driver 205. The micro-pump discharges the liquid in response to the displacement of the diaphragm 6, which is operatively associated with the piezo-electric element 7. In other words, the discharge rate of the micro-pump is controlled in accordance with the pulse number representing the number of pulses within the given period.

The pulse frequency control method will now be described.

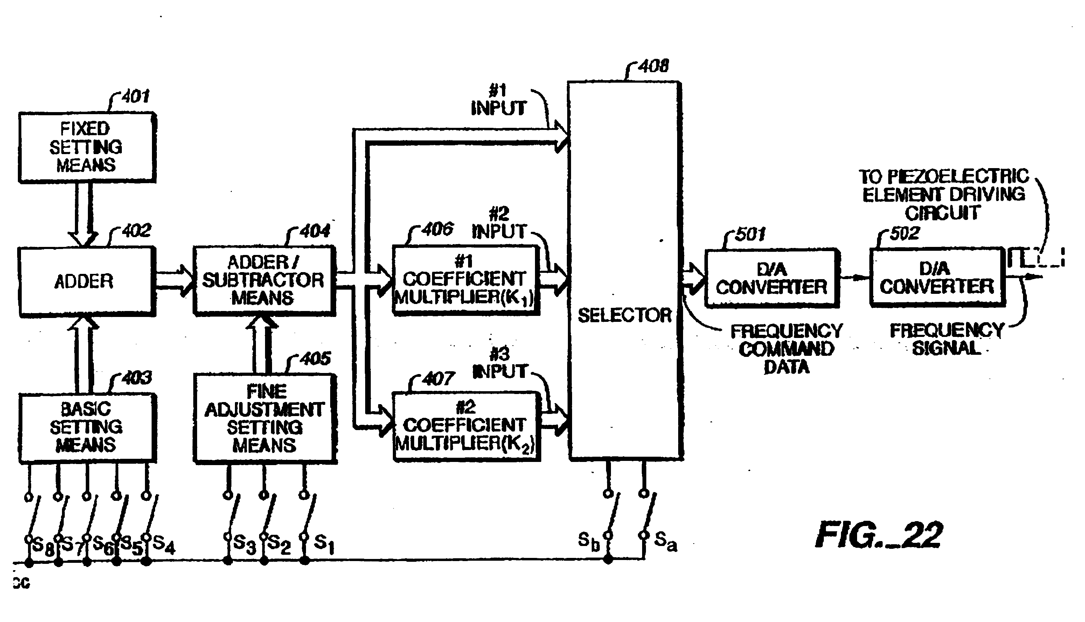

Figure 22 is a block diagram showing an embodiment of pulse frequency control means of the control system according to the present invention. In the Figure, the numerals 401 to 408 designate the same devices as shown in Figure 20. However, the selector 408 is connected to a D/A converter 501 for converting the digital output data to an analog control voltage, and thence to a voltage to frequency (hereinafter referred to as V/F) converter 502, whose oscillation frequency is controlled by its input control voltage.

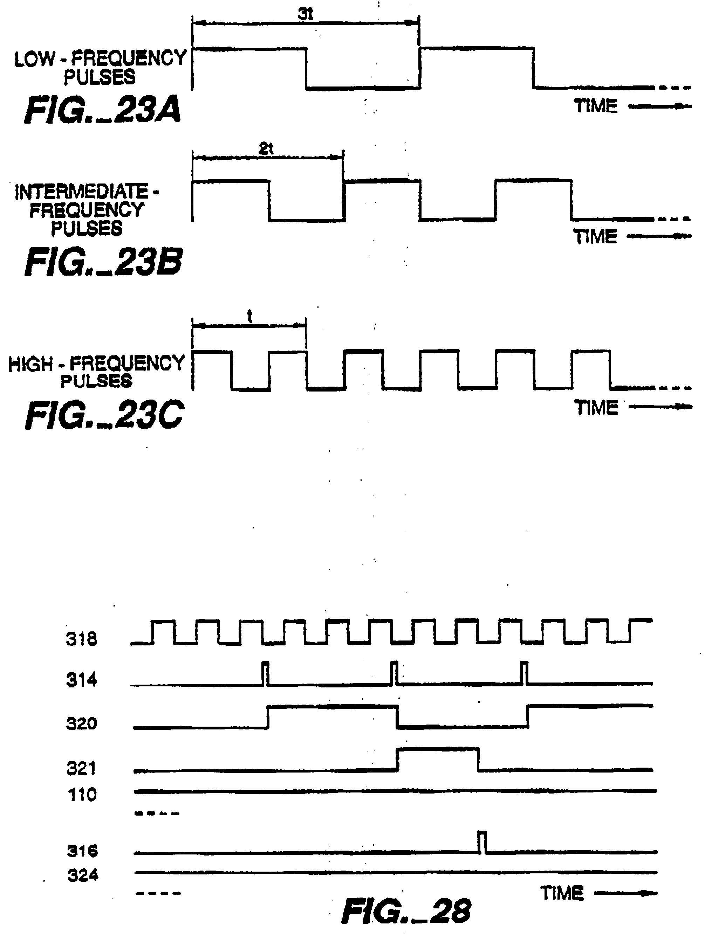

The operation of the circuitry of Figure 22 will now be described with reference to Figure 23. The devices 401 to 408 of Figure 22 operate in an identical manner to their counterparts in Figure 20 except in the following respects. In the system of Figure 20, the operation determines the number of pulses of period $t$ to be supplied within the given overall period T. Thus, it will be seen that there are operating periods where the output pulses of the period $t$ are generated continuously immediately following the application of the trigger signal and rest periods where no output pulses are generated.

In the circuitry of Figure 22, the oscillation frequency of the V/F converter 502 is controlled so that the rest period when no output pulses are generated is reduced to a minimum or zero. That is, the control is effected so as to maintain a constant discharge rate with respect to the time base, thereby reducing the ripple in the discharge rate. As a result, the data set in the fixed setting means 401, the basic setting means 403 and the fine adjustment setting means 405 is data relating to frequencies.

The selector 408 selects one of its three input signals as frequency command data and supplies it to the D/A converter 501. The D/A converter 501 supplies an analog control voltage corresponding to the input data to the V/F converter 502, the V/F converter 502 generates signals of an oscillation frequency controlled by the input control voltage as pulse signals subjected to wave form re-shaping.

Figures 23 (a), 23 (b) and 23 (c) show respectively the wave forms of low frequency pulses, intermediate frequency pulses and high frequency pulses. In the Figure, if the frequency of the high frequency pulses is represented by $f$, the frequency of the intermediate frequency pulses is represented as f/2 and the frequency of the low frequency pulses is represented as f/3. High frequency pulses commonly used in accordance with the frequency classification have a frequency higher than the AC power supply. In this case, however, the frequency $f$ is of the order of 1 Hz to several tens of Hz, which is lower than the frequency of an AC power supply.

It is also possible to modify the circuitry of Figure 22 by providing a frequency divider circuit having a variable frequency dividing ratio in place of the D/A converter 501 and the V/F converter 502, whereby clock signals of a relatively high frequency are generated preliminarily and the clock signals are subjected to frequency division by a desired frequency dividing ratio to produce a lower frequency, thereby digitally generating signals of any desired frequency.

The method of controlling the piezo-electric element driving voltage will now be described. Assuming now that the pulse driving voltage applied to the piezo-electric element 7 is not fixed at 50 V as in the foregoing description but may be continuously varied in the range of for example 30 V to 100 V, then the amount of displacement due to the piezo-electric effect of the piezo-electric element is varied correspondingly and therefore it is possible to control the discharge rate of the micro-pump by utilising the piezo-electric effect. In general, the variable range of the voltage that can be applied to the piezo-electric element 7 to produce the piezo-electric effect is not so wide. However, it is possible to effect analog fine control within this variable range.

The previously mentioned pulse number control method and pulse frequency control method are each digital control methods and therefore the control of the discharge rate per fraction of a pulse cannot be performed as a matter of principle. Thus, the pulse number control method cannot achieve a discharge rate corresponding for example to 35.6 pulses per three minutes. The piezo-electric element driving voltage control method has the advantage that such highly accurate control is possible. Moreover, the control of the piezo-electric element driving voltage can be performed alone or in combination with the other control methods of the pulse number type or the pulse frequency type.

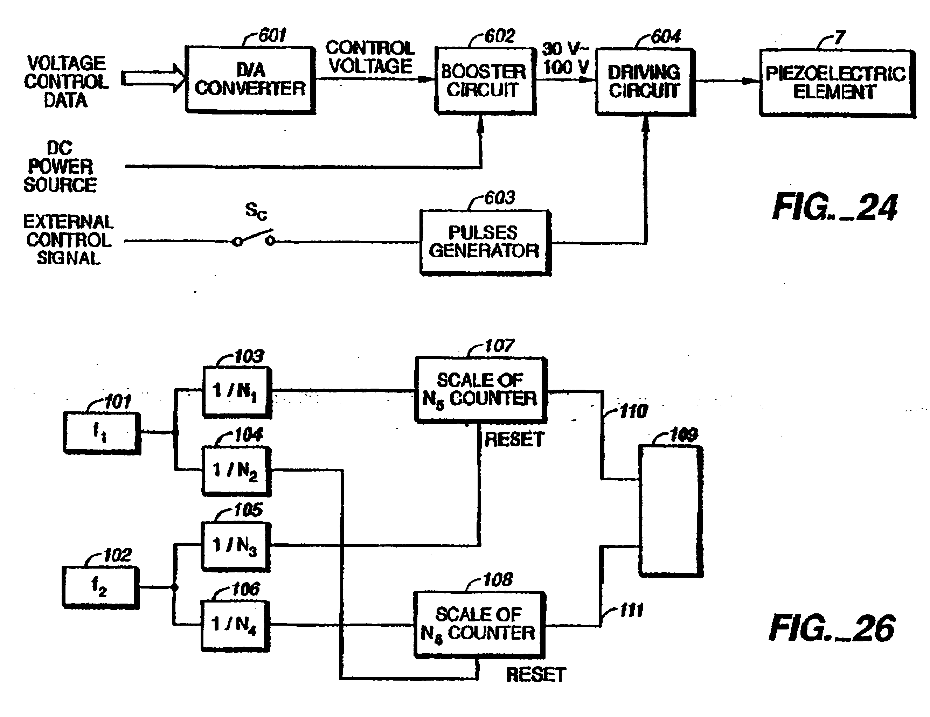

Figure 24 is a block diagram showing an embodiment of piezo-electric element driving voltage control means of the control system according to the present invention comprising a D/A converter 601 for converting voltage control data supplied externally (e.g. supplied by voltage control data command means provided by the devices 401 to 408 of Figure 20) to an analog control voltage. A booster circuit 602 is also provided whereby the voltage of a DC power source, e.g. a battery, is subjected to DC/DC conversion to convert it to a high voltage, the circuit being responsive to the analog control voltage to control the duty cycle of its DC/DC conversion pulses and thereby to variably control its output voltage in a range for example between 30 V and 100 V. A pulse generator 603 generates pulse signals of a given frequency from an internal oscillator thereof when a switch $S_c$ is open and generates pulse signals corresponding to a pulse number or pulse frequency control signal supplied externally when the switch $S_c$ is closed. A driving circuit 604 responsive to the pulse signals from the pulse generator 603 serves to apply the controlled voltage supplied from the booster circuit 602 to the piezo-electric element 7.

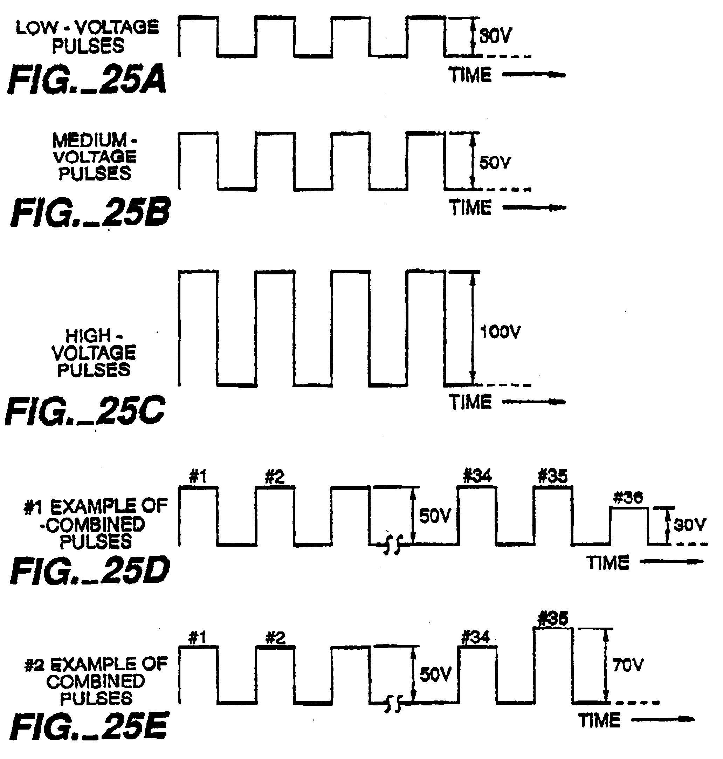

Figure 25 is a wave form diagram for explaining the operation of the circuitry of Figure 24. Figure 25 (a) shows a piezo-electric element driving wave form comprising low voltage (e.g. 30 V) pulses of a given frequency, Figure 25 (b) shows a similar driving wave form comprising medium voltage (e.g. 50 V) pulses of the given frequency and Figure 25 (c) shows a similar driving wave form comprising high voltage (e.g. 100 V) pulses of the given frequency.

Also shown in Figure 25 (d) and Figure 25 (e) are examples of wave forms obtained by the combined pulse number type control and piezo-electric element driving voltage type control. In Figure 25 (d), a case is shown in which for example a discharge rate corresponding to 35.6 pulses within the previously mentioned case of three minutes is obtained by driving the piezo-electric element with #1 to #35 pulses at a voltage of 50 V and with a single #36 pulse at a voltage of 30 V for finally adding the small amount corresponding to 0.6 of a pulse. In Figure 25 (e) a case is shown in which a discharge rate corresponding to 35.4 pulses within three minutes is obtained by driving the piezo-electric element with #1 to #34 pulses at 50 V and with a single #35 pulse at 70 V for finally adding the discharge rate corresponding to 1.4 pulses. In this way, highly accurate discharge rate control can be realised.

Next, a description will be made of a watch-dog timer incorporated in the supervisory control system according to the present invention. It is to be noted that this watch-dog timer overcomes the disadvantage of a conventional watch-dog timer, in which detection is possible only when the frequency of clock signals becomes lower than that in the normal condition but not when the frequency of clock signals becomes higher than that in the normal condition.

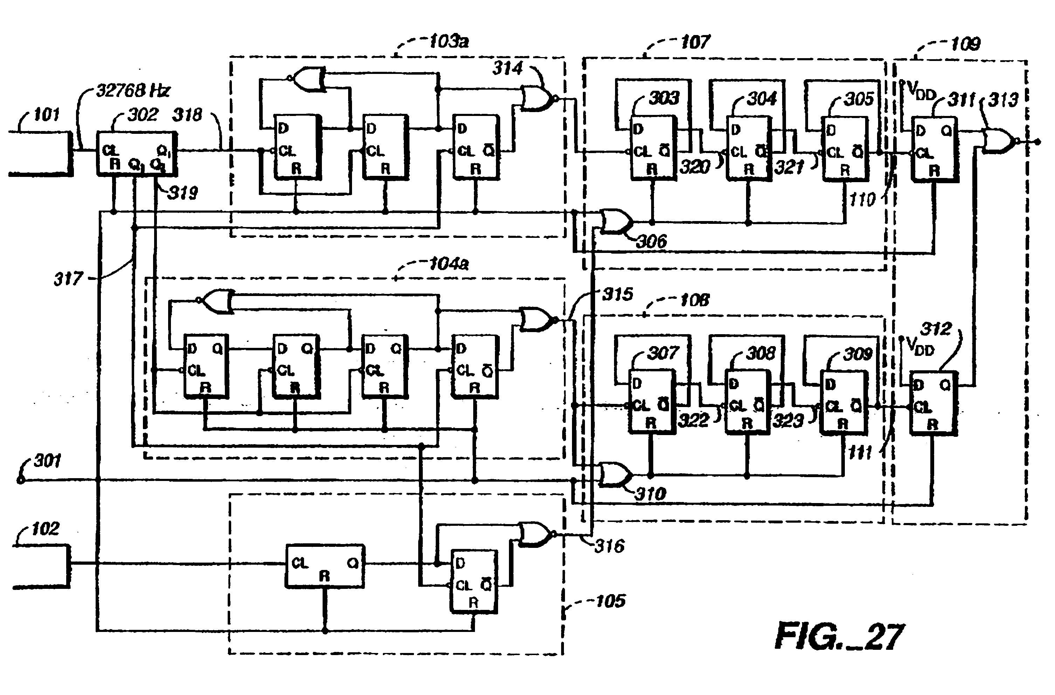

Figure 26 is a block diagram of the watch-dog timer comprising a first clock oscillation circuit 101 having an oscillation frequency $f_1$, and a second clock oscillation circuit 102 having an oscillation frequency $f_2$. A frequency divider circuit 103 subjects the frequency $f_1$ to $1/N_1$ frequency division, and a frequency divider circuit 104 subjects the frequency $f_1$ to $1/N_2$ frequency division. A frequency divider circuit 105 subjects the frequency $f_2$ to $1/N_3$ frequency division, and a frequency divider circuit 106 subjects the frequency $f_2$ to $1/N_4$ frequency division. A counter 107 having a scale of $N_5$ receives the signal having the frequency $f_1/N_1$ output by the frequency divider circuit 103 as a clock input, and the signal having the frequency $f_2/N_3$ output by the frequency divider circuit 105 is a re-set input, and a counter 108 having a scale of $N_6$ receives the signal having the frequency $f_2/N_4$ output by the frequency divider circuit 106 as a clock input and the signal having the frequency $f_1/N_2$ output by the frequency divider circuit 104 as a re-set input. A discrimination circuit 109 discriminates between the output signal 110 of the counter 107 and the output signal 111 of the counter 108.

The operation of the watch-dog timer will now be described.

The counter 107 receives the signal having the frequency $f_1/N_1$ as its clock input and counts the oscillations to thereby generate the output signal 110 for every count $N_5$. In the normal operating condition, however, the counter 107 is re-set by the signal having the frequency $f_2/N_3$ having a relation $f_1/N_1/N_5 < f_2/N_3$ and therefore no output signal 110 is generated.

In a like manner, the counter 108 receives the signal having the frequency $f_2/N_4$ as its clock input and counts the oscillations to thereby generate an output signal 111 for every count $N_6$. In the normal operating condition, however, the counter 108 is re-set by the signal having the frequency $f_1/N_2$ having a relation $f_1/N_4/N_6 < f_1/N_2$ and therefore no output signal 111 is generated.

When neither the output signal 110 nor the output signal 111 is produced, the discrimination circuit 109 determines that the circuit operation is normal.

However, when the first clock oscillation circuit 101 or the frequency divider circuit 104 becomes faulty so that the frequency $f_1/N_2$ decreases, no re-set signal is supplied to the counter 108 at the given timing so that an output signal 111 is generated and applied to the discrimination circuit 109, which in turn determines that the circuit operation is not normal. Similarly, when a fault occurs in the second clock signal oscillation circuit 102 or the frequency divider circuit 105 so that the frequency $f_2/N_3$ decreases, an output signal 110 is generated from the counter 107 and is applied to the discrimination circuit 109, which in turn determines that the circuit operation is not normal.

On the other hand, when a fault occurs in the first oscillation circuit 101 or the frequency divider circuit 103 so that the frequency $f_1/N_1$ increases, an output signal 110 is generated from the counter 107 and applied to the discrimination circuit 109, which in turn determines that the circuit operation is not normal. In a like manner, when a fault occurs in the second clock oscillation circuit 102 or the frequency divider circuit 106 so that the frequency $f_2/N_4$ increases, an output signal 111 is generated from the counter 108 and is applied to the discrimination circuit 109, which in turn determines that the circuit operation is not normal.

Figure 27 is a circuit diagram showing details of the watch-dog timer in Figure 26. The first and second clock oscillation circuits 101 and 102 have their oscillation frequencies selected to be $f_1 = f_2 = 32768$ Hz. A frequency divider circuit 302 is provided whereby the clock signals of 32768 Hz from the first clock oscillation circuit 101 are subjected to frequency division to thereby generate clock signals 318 of 256 Hz, clock signals 319 of 64 Hz and clock signals of a frequency higher than the clock signals 318 and 319. The frequency divider circuit 103 subjects the input signals 318 to 1/3 frequency division and thus with the preceding frequency divider circuit 302 subjects the frequency $f_1$ (= 32768 Hz) to 1/384 frequency division ($N_1 = 384$) to generate clock signals 314 (256/3 Hz). The frequency divider circuit 104 subjects the input signal 319 to 1/5 frequency division and is thus associated with the preceding frequency divider circuit 302 so as to subject the frequency $f_1$ (= 32768 Hz) to 1/2560 frequency division ($N_2 = 2560$) to generate clock signals 315 (64/5 Hz). The frequency divider circuit 105 subjects the input signals from the circuit 102 to 1/1024 frequency division and, in this embodiment, concurrently serves the function of the frequency divider circuit 106 whereby $N_3 = N_4 = 1024$. The clock signals having the frequency $f_2$ of 32768 Hz are thus subjected to 1/1024 frequency division to generate clock signals 316 (32 Hz).

It is to be noted that the clock signals 317 are clock pulses applied to internal differentiation circuits of the frequency divider circuits 103, 104 and 105 for respectively converting the clock signals 314, 315 and 316 to pulse signals of smaller widths.

The counter 107 comprises D type flip flops 303, 304 and 305, thus forming a scale of four counter ($N_5 = 4$) to generate the output signal 110. A OR gate 306 is arranged to receive a system re-set signal 301 and the clock signal 316 such that, when either goes to the level H, the D type flip flops 303, 304 and 305 are re-set.

The counter 108 comprises D type flip flops 307, 308 and 309 forming a scale of four counter ($N_6 = 4$) which generates the output signal 111. An OR gate 310 is arranged to re-set the D type flip flops 307, 308 and 309 when the system re-set signal 301 or the clock signal 315 goes to the level H.

The discrimination circuit 109 includes D type flip flops 311 and 312 arranged such that its output 324 goes to the level L when the output signal 110 or 111 goes from the level H to the level L.

The operation of the present embodiment will now be described.

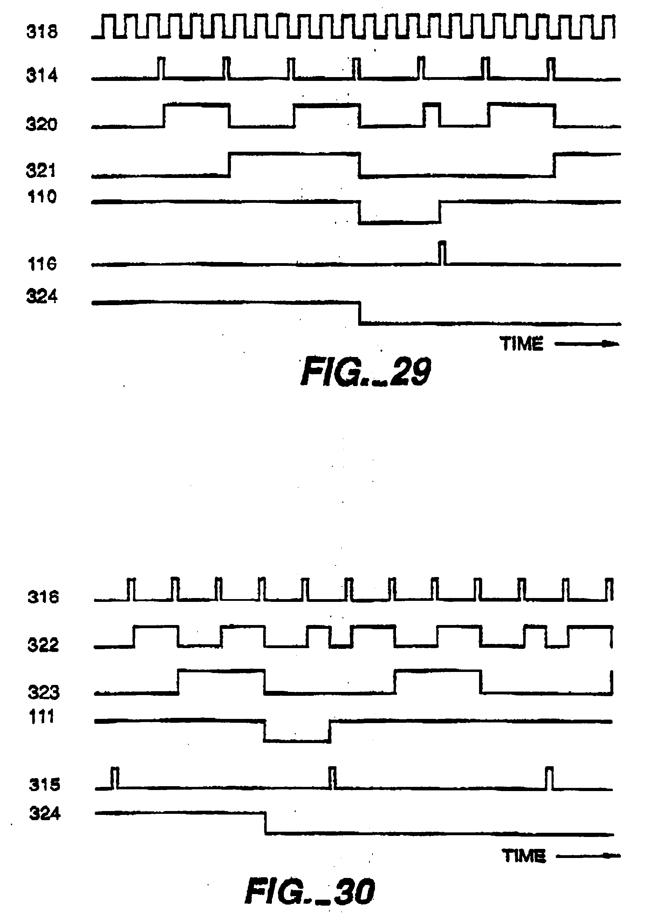

Figure 28 is a timing chart showing the signals during normal operation. All the circuits are first reset by the system re-set signal 301. In the normal condition, $f_1/N_1/N_5 = 32768/384/4$ Hz $= 21.3$ Hz $< f_2/N_3 = 32768/1024 = 32$ Hz and the scale of four counter 107 counting the clock signals 314 (256/3 Hz) is re-set by the clock signal 316 before counting four clock signals, thereby causing the output signal 110 to remain at the level H.

Likewise, in the normal condition, $f_2/N_4/N_6 = 32768/1024/4$ Hz $= 8$ Hz $< f_1/N_2 = 32768/2560 = 12.8$ Hz and the scale of four counter 108 counting the clock signals 316 (32 Hz) is re-set by the clock signal 315 before counting four clock signals, thereby causing the output signal 111 to remain at the level H.

Therefore, the output signal 324 of the discrimination circuit 109 is maintained at the level H.

Figure 29 is a timing chart showing the signals when the first clock oscillation circuit 101 produces harmonic oscillations. When the first clock oscillation circuit 101 produces harmonic oscillations so that the oscillation frequency becomes two times that in the normal condition or 65536 Hz, the result is $f_1/N_1/N_5 = 65536/384/4$ Hz $= 42.7$ Hz $> f_2/N_3 = 32768/1024$ Hz $= 32$ Hz and the scale of four counter 107 counts four clock signals before it is re-set by the clock signal 316. Thus, the output signal 110 changes from the level H to the level L and it is latched by the D type flip flop circuit 311, thus causing the output 324 of the discrimination circuit 109 to go to the level L, thereby indicating the occurrence of a fault in the circuit.

In the same way, when $f_2/N_1/N_5 > f_2/N_3$, due to any other reason such as a decrease in the oscillation frequency of the second clock oscillation circuit 102, the occurrence of a fault in the circuit can be detected.

Figure 30 is a timing chart showing the signals when the second clock oscillation circuit 102 produces harmonic oscillations so that the oscillation frequency $f_2$ becomes two times that in the normal condition, or 65536 Hz. In this case, the result is $f_2/N_4/N_6 = 65536/1024/4$ Hz $= 16$ Hz $> f_1/N_2 = 32768/2560$ Hz $= 12.8$ Hz so that the scale of four counter 108 counts four clock signals before it is re-set by a clock signal 315. Thus, its output signal 111 goes from the level H to the level L and it is latched by the D type flip flop circuit 312, thus causing the output 324 of the discrimination circuit 109 to go to the level L, thereby indicating the occurrence of a fault in the circuit.

13

In the same manner, when $f_2/N_4/N_6 > f_1/N_2$ due to any other cause such as a decrease in the oscillation frequency of the first clock oscillation circuit 101, the occurrence of a fault can also be detected.

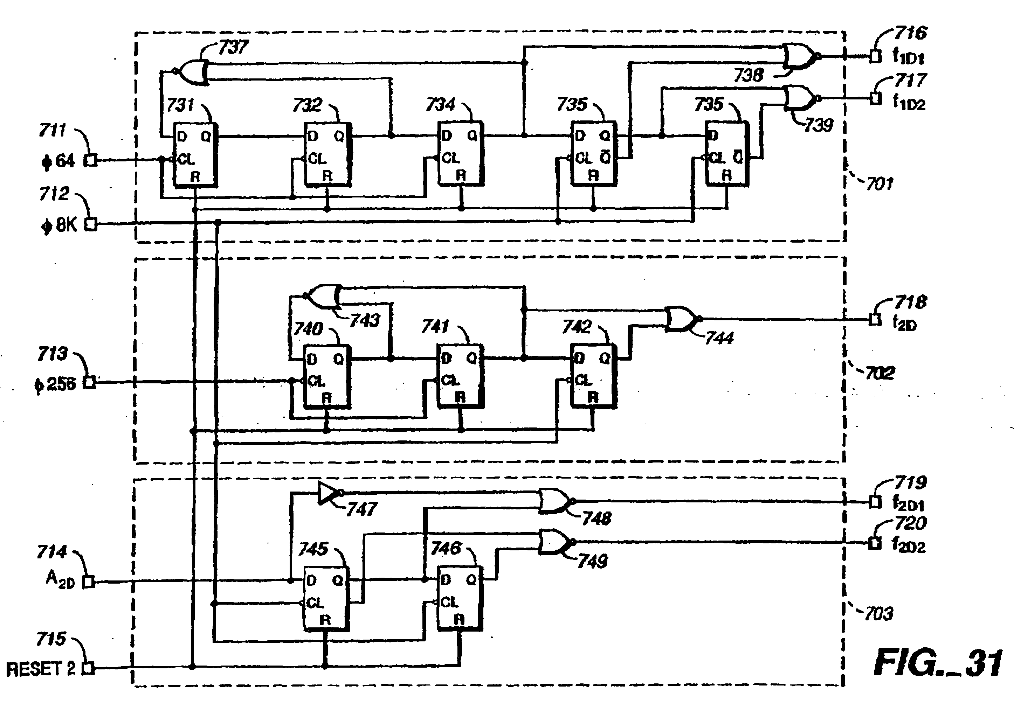

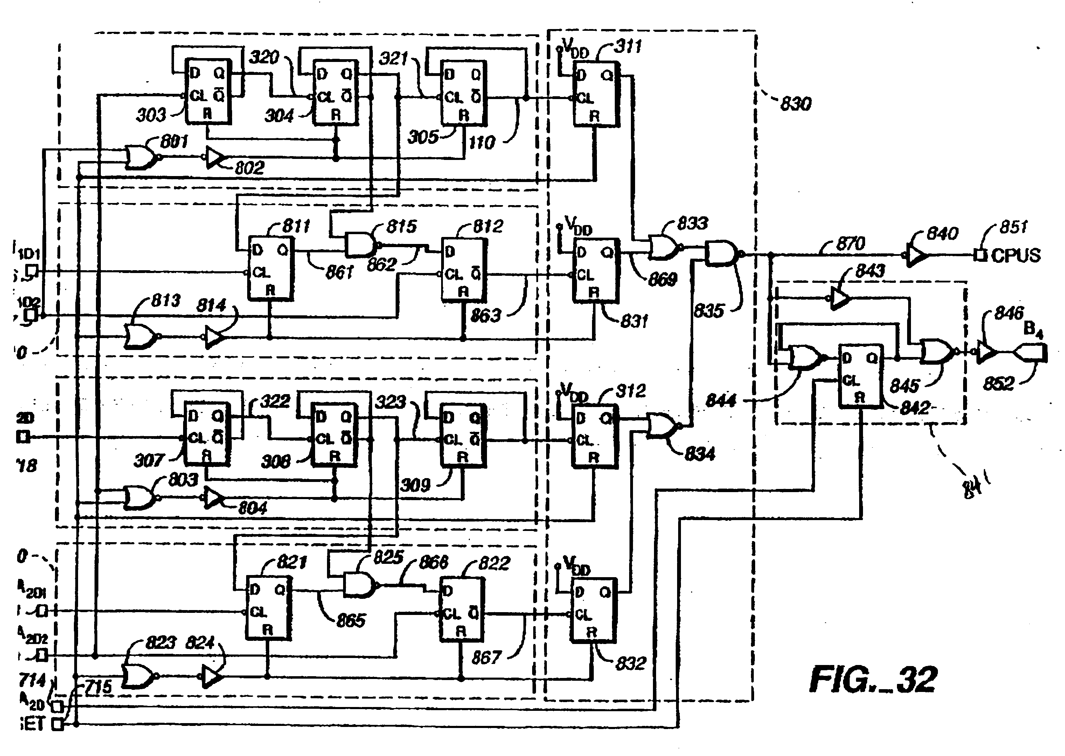

Figures 31 and 32 are circuit diagrams of another watch-dog timer, with Figure 31 showing its frequency divider circuit section and Figure 32 showing its fault discrimination processing section. In this embodiment, functions for checking the operation of the counter 107, the counter 108 and an output stage are added.

Referring to Figure 31, a frequency divider circuit 701 for subjecting input signals to 1/5 frequency division includes D type flip flop circuits 731 to 736 and NOR gates 737 to 739. Clock signals 711 having a frequency of 64 Hz and clock signals 712 having a frequency of 8 kHz are applied to the frequency divider circuit 701, the clock signals 711 having the 64 Hz frequency being subjected to the 1/5 frequency division to generate clock signals 716 and 717 which are slightly shifted in phase from each other. A frequency divider circuit 702 for subjecting input signals to 1/3 frequency division includes D type flip flop circuits 740 to 742 and NOR gates 743 and 744. The frequency divider circuit 702 receives clock signals 713 having a frequency of 256 Hz and subjects these to the 1/3 frequency division thereby generating clock signals 718 of approximately 85.3 Hz. A shift circuit 703 includes D type flip flop circuits 745 and 746 and NOR gates 747 to 749. The shift circuit 703 receives clock signals 714 having a frequency of 32 Hz to generate clock signals 719 and 720 which are slightly shifted in phase from each other.

It is to be noted that the clock signals 711, 712 and 713 are signals produced by the frequency division of the output of the first clock oscillation circuit 101 in Figure 27 and the clock signals 714 are signals produced by the frequency division of the output of the second clock oscillation circuit 102. Thus, the production of these clock signals 711 to 714 will not be explained. It is assumed that the first clock oscillation circuit 101 and the second clock oscillation circuit 102 are respectively incorporated in different ICs. For instance, it is assumed that the first clock oscillation circuit 101, the frequency divider circuits (not shown) for producing the clock signals 711 to 713 and the circuits of Figures 31 and 32 are incorporated in a first IC (e.g. the IC 30 in Figure 2) and the second clock oscillation circuit 102 and the circuits for generating the clock signals 714 and 715 are incorporated in a second IC (e.g. the IC 31 in Figure 2). A signal 715 is a re-set signal which is generated from the second IC incorporating the second oscillation circuit 102 as mentioned previously so as to re-set the D type flip flop circuits of the previously mentioned circuits 701 to 703.

Referring to Figure 32, gate circuits 801, 802 are arranged to generate a re-set signal for the D type flip flop circuits 303 to 305 of the counter 108. Gate circuits 803, 804 are arranged to generate a re-set signal for the D type flip flop circuits 307 to 309 of the counter 107. A counter check circuit 810 serves for checking the operation of the counter 108 and includes D type flip flop circuits 811 and 812 and gate circuits 813 to 815. A counter check circuit 820 serves for checking the operation of the counter 107 and includes D type flip flop circuits 821 and 822 and gate circuits 823 to 825.

A discrimination circuit 830 includes, in addition to the D type flip flop circuits 311 and 312 of Figure 27, D type flip flop circuits 831 and 832, for respectively latching the outputs of the counter check circuits 810 and 820, and gate circuits 833 to 835. A gate circuit 840 and an output stage check circuit 841 are also provided. The output stage check circuit 841 includes a D type flip flop circuit 842 and gate circuits 843 to 845. A gate circuit 846 is arranged on the output side of the output stage check circuit 841. A detection signal 851 to be applied to the first IC and a detection signal 852 to be sent to the second IC are generated as outputs.

The operation of this embodiment will now be described. It is to be noted that the operations for detecting faults due to variations in the frequencies of the various clock signals are the same as the operations in the embodiment in Figure 27 and will not be described.

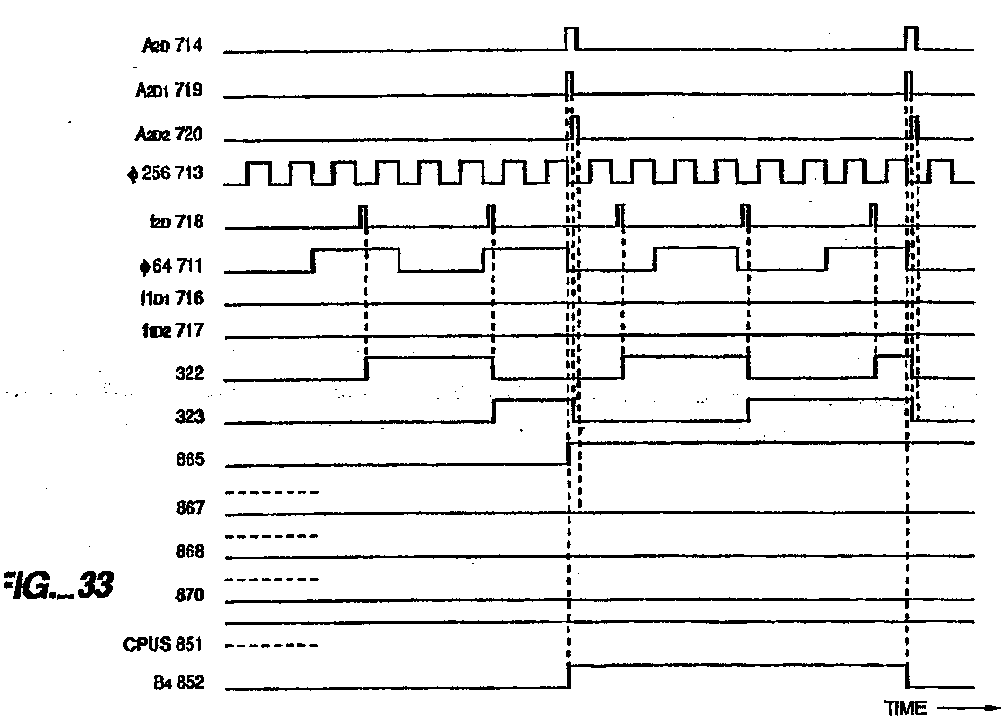

Figure 33 is a timing chart showing the clock signals of Figure 31 and the operation of the counter check circuit 820 of Figure 32. The clock signals 714, 719, 720, 713, 718, 711, 716 and 717 are each applied at the timing shown. For instance, the D type flip flop circuit 307 of the counter 108 receives the clock signals 718 as inputs and applies it output signals 322 as clock signals to the D type flip flop circuit 308. The output signals 323 of the D type flip flop circuit 308 are applied as clock signals to the following D type flip flop circuit 309 and are also applied to the data terminal of the D type flip flop circuit 821 of the counter check circuit 820. Also, the inverted output signal $\overline{323}$ is applied to the gate circuit 825.

When the clock signal 719 is applied as a clock signal to the D type flip flop circuit 821 with the output signal 323 at the level H, its output 865 goes to the level H. Then, when the clock signal 720 is applied to the re-set terminal of the D type flip flop circuit 308, its output signal 323 goes to the level L and its inverted signal is applied to the gate circuit 825. The signal 865 (level H) and the inverted signal $\overline{323}$ (level H) are applied to the gate circuit 825 so that its output signal 866 goes to the level L and is applied as a data signal to the D type flip flop circuit 822. At this time, the clock signal 720 is also applied to the clock terminal of the D type flip flop circuit 822 and thus the output signal 867 of the circuit 822 remains at the level H.

In other words, when there is a change between the outputs of the D type flip flop circuit 308 before and after its re-setting, the output signal 867 of the D type flip flop circuit 822 remains at the level H and it is known that the counter 107 is operating properly.

The output signal 867 of the D type flip flop circuit 822 is input to the D type flip flop circuit 832 as a clock signal and the output signal (the level L at this time) is sent to the gate circuits 834 and 835. If there is no fault in the other circuits and the output signals of the D type flip flop circuits 311, 312 and 831 are thus maintained at the level L, the output signal 870 of the gate circuit 835 goes to the level L and thus a detection signal 851 (the level H at this time) is sent to the first IC through the gate circuit 840.

In the output stage fault detecting circuit 841, the output signal 870 of the gate circuit 835 is applied to the gate circuit 844 so that an inverted signal is applied to the data terminal of the D type flip flop circuit 842, whose clock signal terminal receives the clock signal 714. Its output is applied to the gate circuits 844 and 845. When the output of the gate circuit 845 is delivered as a detection signal 852 to the second IC through the gate circuit 846, the signal 852 is switched between the levels H and L repeatedly in synchronism with the signal 714. When a fault occurs in the output stage fault detecting circuit 841, its output signal assumes one or other of the levels H and L and thus it is possible to detect the occurrence of the fault.

However, if the output signal 323 of the D type flip flop circuit 308 fails to change from the level H to the level L when a re-set signal is applied to the counter 107, the following operation takes place: When the clock signal 719 is applied to the clock terminal of the D type flip flop circuit 821 with the output signal 323 at the level H, its output 865 goes to the level H. Then, when the clock signal 720 is applied to the re-set terminal of the D type flip flop circuit 308, its output signal 865 which should go to the level L fails to do so, and the output signal 865 (level H) and the inverted signal $\overline{323}$ (level L) remain as they are applied to the gate circuit 825. The output signal 866 thus remains at the level H and is applied as a data signal to the D type flip flop circuit 822. At this time, the clock signal 720 is also applied to the clock terminal of the D type flip flop circuit 822 and thus the output signal 867 of the circuit 822 goes to the level L. In other words, if there is no difference between the outputs of the D type flip flop circuit 822 before and after the re-setting of the D type flip flop circuit 308, the output signal 867 of the D type flip flop circuit 822 goes to the level L and it is known that the counter 107 is not operating properly.

The output signal 867 of the D type flip flop circuit 822 is input as the clock signal to the D type flip flop circuit 832 and the output signal (the level H at this time) is delivered to the gate circuits 834 and 835. Thus, even if the other circuits are not faulty and the output signals of the D type flip flop circuits 311, 312 and 831 at the level L, the output signal 870 of the gate circuit 835 goes to the level H and an L level detection signal 851 is delivered to the first IC through the gate 840.

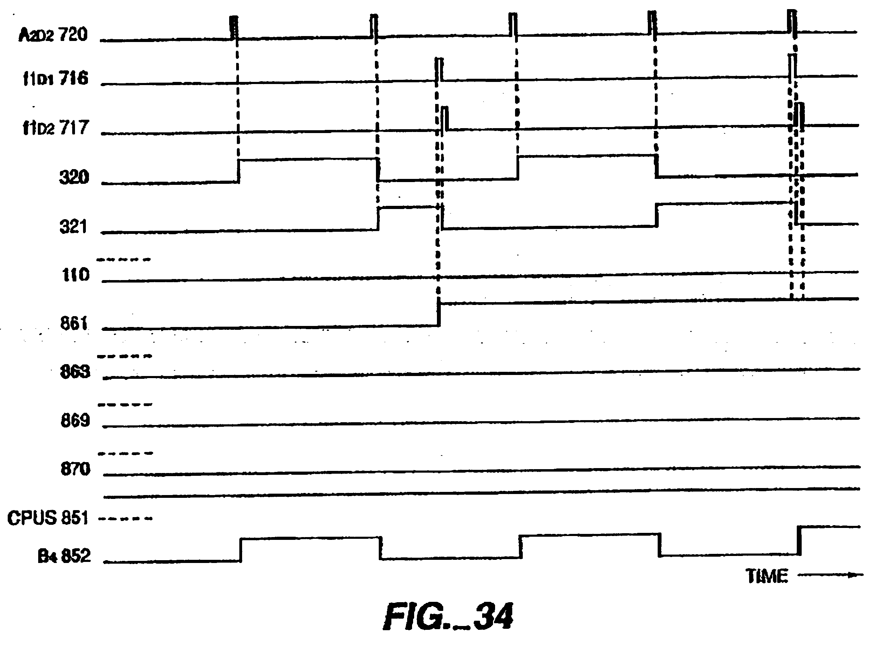

Figure 34 is a timing chart showing the operation of the counter check circuit 810.

The counter check circuit 810 operates in the same way as the previously mentioned counter check circuit 820 so that the output signal 321 of the D type flip flop circuit 304 is applied as a clock signal to the following D type flip flop circuit 305 and is also applied to the data terminal of the D type flip flop circuit 811 and the counter check circuit 810. Also, the inverted output signal $\overline{321}$ is applied to the gate circuit 815. With the output signal 321 at the level H, when the clock signal 716 is applied to the clock terminal of the D type flip flop circuit 811, its output signal 861 goes to the level H. Then, when the clock signal 717 is applied to the re-set terminal of the D type flip flop circuit 304, its output signal 321 goes to the level L and the inverted signal $\overline{321}$ is applied to the gate circuit 815. The output signal 861 (level H) and the inverted output signal $\overline{321}$ (level H) are applied to the gate circuit 815 so that its output signal 862 goes to the level L, this output signal 862 being applied as a data signal to the D type flip flop circuit 812. At this time, the clock signal 717 is also applied to the clock terminal of the D type flip flop circuit 812 so that the output signal 863 of the circuit 812 remains at the level H and it is known that the counter 108 is operating properly.

However, if the output signal 321 of the D type flip flop circuit 304 fails to change from the level H to the level L when a re-set signal is applied to the counter 108, the output signal 861 (level H) and the inverted output signal $\overline{321}$ (level L) are continuously applied to the gate circuit 815 and its output signal 862 also remains at the level H, thereby applying the output signal 862 as a data signal to the D type flip flop circuit 812. At this time, the clock signal 717 is applied to the clock terminal of the D type flip flop circuit 812 and the output signal 863 of the circuit 812 goes to the level L. As a result, it is known that the counter 108 is not operating properly.

As described above, in accordance with the above mentioned watch-dog timer, when any fault occurs in each of the clock oscillation circuits, etc. so that the frequency of the frequency divided clock signals increases or decreases, the fault can be detected. In addition, the use of the two clock signal oscillation circuits permits mutual confirmation of the operation of the two circuits, and further the operation of the faulty operation detecting circuit itself is also checked thereby further enhancing the safety. Therefore, the present invention is very suitable for use as a control system in fields of application requiring high reliability, self-diagnosis functions, etc., such as medical injection apparatus, measuring apparatus and security apparatus.

Next, a description will be made of a soft start circuit for a switching regulator for driving the piezo-electric element, which circuit is incorporated in the micro-pump supervisory control system of Figure 19 according to the present invention.

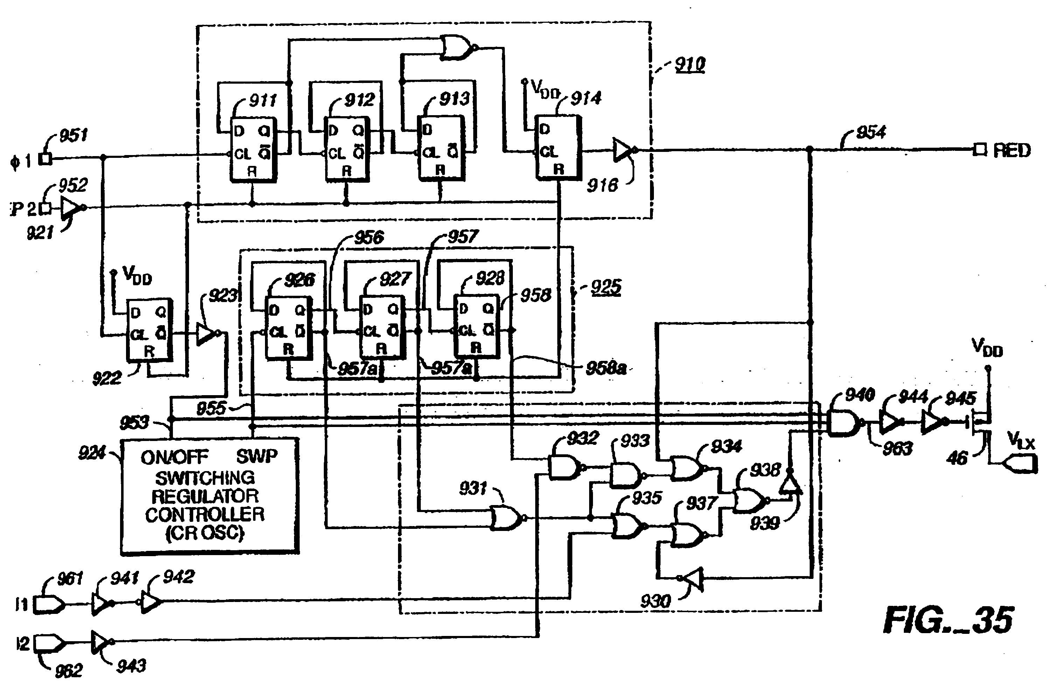

Figure 35 is a circuit diagram showing the soft start circuit for the switching regulator in this embodiment of the present invention. The circuit comprises a timer circuit 910 for generating an initial condition release signal, which includes D type flip flop circuits 911 to 914, a gate circuit 915 and an inverter 916. An inverter circuit 921, a D type flip flop circuit 922 and an inverter circuit 923 are also provided. A switching regulator controller 924 receives a driving command signal through the inverter circuit 921, the D type flip flop circuit 922 and the inverter circuit 923.

A frequency divider circuit 925 includes D type flip flop circuits 926 to 928 for dividing an oscillation frequency output by the switching regulator controller 924. A gate control circuit 930 includes logical gate circuits 931 to 935, 937 and 938 and inverters 936 and 939. A gate circuit 940 comprises a NAND circuit. Inverter circuits 941 to 945, and a switching transistor 946 are also provided.

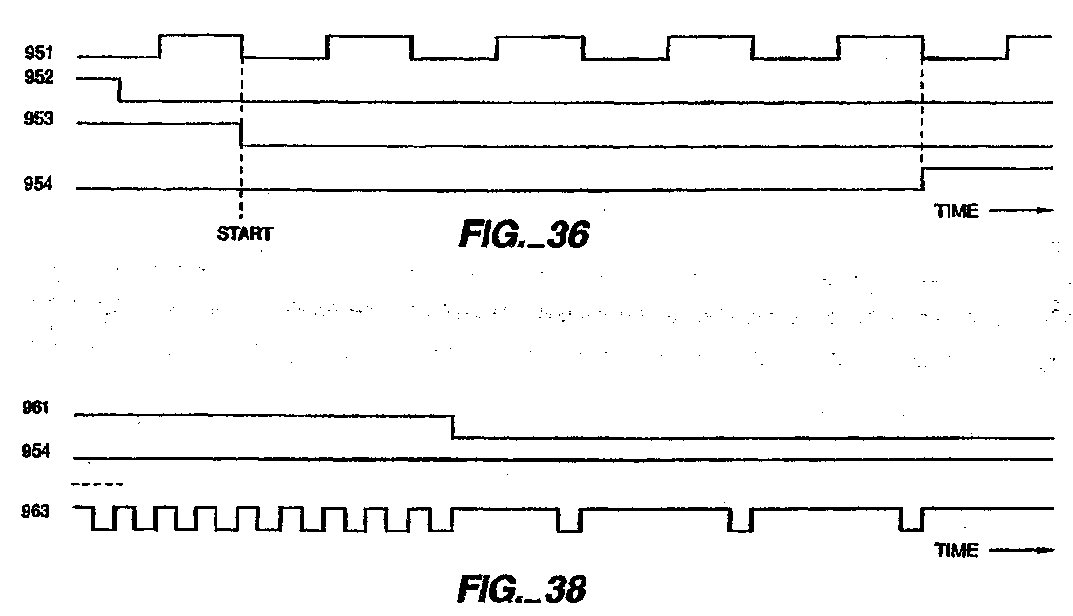

Figure 36 is a timing chart showing the operation of the timer circuit 910 of the D type flip flop circuit 922. When clock signals 951 having a frequency of 1 Hz are applied to the clock terminal of the D type flip flop circuits 911 and 922, respectively, and a start signal 952 goes to the level H in this condition, a start signal 952 is inverted by the inverter circuit 921 and is applied to the re-set terminals of the D type flip flop circuits 911 to 914 and 922, thereby releasing the re-setting of these circuits. Then, the D type flip flop circuit 922 latches an input from the data terminal $V_{DD}$ at the falling edge of the clock signal 951 and outputs its inverted output as a driving command signal 953 to the switching regulator controller 924 through the inverter 923.

Also, in the timer circuit 910, the clock signals 951 are subjected to 1/4 frequency division, the resulting output being applied to the clock terminal of the D type flip flop circuit 914 as the clock signal and delivered as an initial condition release signal 954 through the inverter 916. In other words, the initial condition release signal 954 remains at the level L for four seconds after the application of the start signal 952, and during this interval the gate control circuit 930 operates in an initial condition as will be described later. Then, at the expiration of four seconds, the initial condition release signal 954 goes to the level H and the initial condition is released and the gate control circuit operates in a steady state condition.

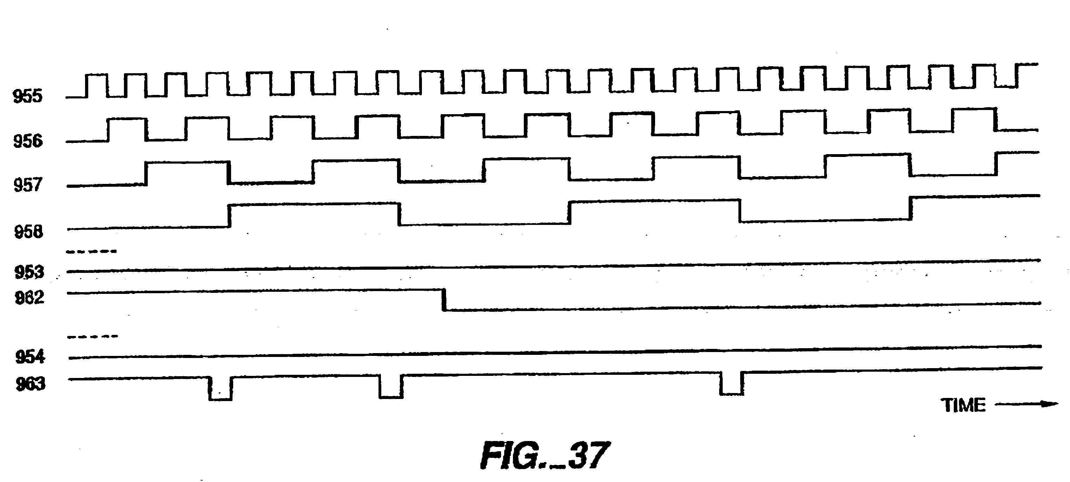

Figure 37 is a timing chart showing the signals of the soft start circuit in the initial condition.

The oscillation pulses 955 of the switching regulator controller 924 are applied to the frequency divider circuit 925 and the pulses 955 are subjected to frequency division by the D type flip flop circuits 926 to 928, respectively, and output signals 956 to 958 are produced. At this time, it is assumed that a control signal 961 at the level L has been supplied and a control signal 962 at either the level H or L has been supplied. Note that the control signal 961 is a signal for determining the frequency of the output in the steady state condition and the control signal 962 is a signal for determining the frequency of the output in the initial condition. The frequency divider circuit 925 and the gate control circuit 930 operate in such a manner that, when the control signal 962 is at the level H, the frequency of the oscillation pulses 955 is subjected to 1/4 frequency division and an output of the resulting frequency is generated, whereas, when the control signal 962 is at the level L, the frequency of the oscillation pulses 955 is subjected to 1/8 frequency division and an output of the resulting frequency is generated.

The inverted output signals 956a and 957a from the D type flip flop circuits 926 and 927 of the frequency divider circuit 925 are applied to the NOR circuit 931 of the gate control circuit 930, and the inverted output signal 958a of the D type flip flop circuit 928 and the control signal 962 inverted by the inverter circuit 943 are applied to the NAND circuit 932. While the output of the NOR circuit 931 and the output of the NAND circuit 932 are applied to the NAND circuit 933, the output of the NAND circuit 932 is fixed at the level H (this has the effect that the output signal of the D type flip flop circuit 928 is thereafter ignored) and thus the output of the NAND circuit 933 is the inverted output from the NOR circuit 931. Since the initial condition release signal 954 (level L at this time) is applied to the NOR circuit 934, this generates as its output signal the output of the NAND circuit 933 inverted.

On the other hand, the initial condition release signal 954 at the level L is applied to the NOR circuit 937 through the inverter circuit 936 so that its output is fixed at the level L and the control signal 961 is ignored. Then, the output of the NOR circuit 934 and the output of the NOR circuit 937 (level L) are applied to the NOR circuit 938 and the inverted signal from the NOR circuit 934 is delivered as a gate control signal through the inverter 939.

The drive command signal 953, the oscillation pulses 955 and the above mentioned gate control signal are applied to the gate circuit 940 so that the gate circuit 940 generates output signals 963 having the same pulse width as the oscillation pulses 955 and a frequency obtained by dividing the frequency of the oscillation pulses 955 by a factor of four, thereby driving the switching transistor 946 through the inverters 944 and 945.

When the control signal 962 goes to the level L, the level H is applied to the NAND circuit 932 so that it inverts the inverted output signal 958a of the D type flip flop circuit 928 and the same operation as mentioned previously is performed, thereby delivering output signals 963 having the same pulse width as the oscillation pulses 955 and a frequency obtained by dividing the frequency of the oscillation pulses 955 by a factor of eight.

As described hereinabove, during the initial condition or during the time that the initial condition release signal 954 remains at the level L, output pulses of 1/4 or 1/8 the frequency of the oscillation pulses 955 are generated.

Figure 38 is a timing chart showing the operation in the steady state condition. It is assumed that in this condition the initial condition release signal 954 is at the level H and also that the control signal 961 is primarily set to the level H.

The control signal 961 (the level H) is applied to the NOR circuit 935 through the inverters 941 and 942 so that its output is fixed at the level L, and the output of the NOR circuit 935 (level L) and the inverted initial condition release signal 954 (level L) from the inverter 936 are applied to the NOR circuit 937 thus causing its output to go to level H. When this occurs, a gate control signal (the level H at this time) is delivered to the gate circuit 940 through the NOR circuit 938 and the inverter 939 and thus inverted oscillation pulses 955 are delivered as output signals 963 from the gate circuit 940.

On the other hand, if the control signal 961 drops to the level L while the initial condition release signal 954 set at the level H is applied to the NOR circuit 934 thus holding its output at the level L, the control signal 961 is applied to the NOR circuit 935 through the inverters 941 and 942. Therefore, the output from the NOR circuit 931 is inverted and delivered to the following circuits and the same operation as mentioned previously is performed. Thus, gate control signals resulting from 1/4 frequency division of the oscillation pulses 955 and having a pulse width which is two times that of the oscillation pulses 955 are supplied to the gate circuit 940, and the gate circuit 940 generates output signals 963 having 1/4 the frequency of and the same pulse width as the oscillation pulses 955.

In the above mentioned embodiment, the duration of the initial condition is set to be four seconds, but this time period can be determined as desired and the corresponding output frequency can be determined arbitrarily.

From the foregoing description, it will be seen that, since the switching regulator is designed so that its output frequency can be arbitrarily changed between the initial condition and the steady state condition, the output frequency can be increased after the power supply voltage has risen fully. Moreover, there are advantages in that there is no danger of frequency variation due to the digital processing, and that the frequency can be set appropriately.

## Claims

1. A liquid medicine injection apparatus including a control system for a micro-pump, the control system comprising means for generating driving pulses for application to a piezo-electric element (7) for driving the pump, and characterised by means (200, 400) for controlling the discharge of fluid by the pump by selectively controlling the generation of the driving pulses, the control means comprising setting means (31, 403, 405) responsive to input driving pulse data for setting a value for a given characteristic of the driving period, and level selection means (30, 408) responsive to a switch input for selecting between fractional quantities of the set characteristic whereby to provide precise control of the discharge rate of the pump.

2. A liquid medicine injection apparatus according to claim 1 characterised in that the given characteristic comprises the number of driving pulses generated in the predetermined driving period.

3. A liquid medicine injection apparatus according to claim 1 characterised in that the given characteristic comprises the frequency of the driving pulses generated in the predetermined driving period.

4. A liquid medicine injection apparatus according to any of claims 1 to 3 characterised in that the given characteristic comprises the amplitude of the driving pulses generated in the predetermined driving period.

5. A liquid medicine injection apparatus according to any preceding claim characterised in that the setting means comprise basic setting means (403) for setting a basic value for the given characteristic, and fine adjustment means (405) for correcting the basic value.

6. A liquid medicine injection apparatus according to any preceding claim characterised in that the level selection means comprise a selector (408) and means for supplying the set value directly and by way of at least one co-efficient multiplier (406, 407), respectively, to the selector.

7. A liquid medicine injection apparatus as claimed in any preceding claim characterised by means (30) for monitoring the remaining product life of the fluid, the monitoring means comprising a timer arranged to start counting to a pre-set value upon receipt of a start signal (H at OPIN), means for resetting the timer to an intermediate value upon actuation of a switch (C), the intermediate value comprising the pre-set value minus an integer quantity representing the time that has passed following receipt of the start signal, and means (BZ) for generating a warning in response to the time reaching the pre-set value to signify that the remaining product life of the fluid is approaching and/or has reached expiry.

8. A liquid medicine injection apparatus as claimed in any preceding claim, characterised in that the control means comprise means for monitoring a detection potential at a terminal ($V_{DE}$) for supplying the driving pulses to the piezo-electric element, the monitoring means comprising means for sampling the detection potential at predetermined times in a driving period, means for comparing the sampled detection potential with a reference, and means (BZ) for generating a warning in response to an output from the comparing means.

9. A liquid medicine injection apparatus as claimed in claim 1 characterised by means for supplying clock pulses for controlling the timing of the generating means and the control means, the control means comprising means for monitoring the frequency of the clock pulses, the supply means comprising first and second clock oscillation frequency generating means (101, 102) and the monitoring means comprising first and second counters (107, 108), the first counter (107) being arranged to count in response to the first clock oscillation frequency and to be re-set in response to the second clock oscillation frequency and the second counter (108) being arranged to count in response to the second clock oscillation frequency and to be reset in response to the first clock oscillation frequency, and frequency dividing means (103 to 106) arranged between the clock oscillation frequency generating means and the counters, the arrangement being such that the first counter generates an output in response to an increase in the first clock oscillation frequency of the clock pulses or a decrease in the second clock oscillation frequency and the second counter generates an output in response to a decrease in the first clock oscillation frequency or an increase in the second clock oscillation frequency.

10. A liquid medicine injection apparatus as claimed in claim 1 characterised in that the control means comprise a soft start circuit of a switching regulator for controlling generation of the switching pulses at a reduced frequency during a predetermined period following supply of a start signal, the soft start circuit comprising a timer (910) responsive to the start signal to time the pre-determined period and to generate an initial condition release signal on expiry of the predetermined period, a frequency divider circuit (925) for dividing the frequency of input clock pulses, and gate means (930, 940) arranged during the predetermined period to supply an output from the frequency divider circuit to the means for generating the driving pulses and, in response to the initial condition release signal, to supply the input clock pulses to the means for generating the driving pulses.

11. A supervisory control method for a liquid medicine injection apparatus as claimed in any preceding claim characterised by the steps of performing at least one of a discharge demonstration for driving said micro-pump over a given period of time to deliver a liquid, an alarm demonstration for producing life prediction and life expiration warning alarms, and an operation acknowledge sound demonstration for producing an alarm of a given sound pattern.

**Patentansprüche**

1. Einrichtung zum Einspritzen flüssiger Medizin, umfassend ein Steuersystem für eine Mikropumpe, wobei das Steuersystem Mittel zum Erzeugen von Antriebsimpulsen zum Anlegen an ein piezoelektrisches Element (7) umfaßt, um die Pumpe anzutreiben, und
**gekennzeichnet durch**
ein Mittel (200, 400) zum Steuern der Fluidabgabe durch die Pumpe durch wahlweises Steuern der Erzeugung der Antriebsimpulse, wobei das Steuermittel Setz-Mittel (31, 403, 405) umfaßt, welche auf eingegebene Antriebsimpulsdaten zum Setzen eines Wertes für eine gegebene Charakteristik der Antriebsperiode ansprechen, sowie Pegelauswahlmittel (30, 408), welche auf eine Schalteingabe zum Auswählen zwischen Bruchteilsmengen der gesetzten Charakteristik ansprechen, um dadurch eine präzise Steuerung der Abgaberate der Pumpe vorzusehen.

2. Einrichtung zum Einspritzen flüssiger Medizin nach Anspruch 1, dadurch gekennzeichnet, daß die vorgegebene Charakteristik die Anzahl an Antriebsimpulsen umfaßt, welche in der vorbestimmten Antriebsperiode erzeugt werden.

3. Einrichtung zum Einspritzen flüssiger Medizin nach Anspruch 1, dadurch gekennzeichnet, daß die vorgegebene Charakteristik die Frequenz der Antriebsimpulse umfaßt, welche in der vorbestimmten Antriebsperiode erzeugt werden.

4. Einrichtung zum Einspritzen flüssiger Medizin nach einem der Ansprüche 1 bis 3, dadurch gekennzeichnet, daß die vorgegebene Charakteristik die Amplitude der Antriebsimpulse umfaßt, welche in der vorbestimmten Antriebsperiode erzeugt werden.

5. Einrichtung zum Einspritzen flüssiger Medizin nach einem der vorhergehenden Ansprüche, dadurch gekennzeichnet, daß die Setz-Mittel Basis-Setzmittel (403) zum Setzen eines Basiswertes für die gegebene Charakteristik umfassen sowie Feineinstellungsmittel (405) zum Korrigieren des Basiswertes.

6. Einrichtung zum Einspritzen flüssiger Medizin nach einem der vorhergehenden Ansprüche, dadurch gekennzeichnet, daß die Pegelauswahlmittel einen Auswähler (408) und Mittel zum Zuführen des gesetzten Wertes zu dem Auswähler direkt bzw. vermittels wenigtens eines Koeffizientenmultiplizierglieds (406, 407) umfassen.

**7.** Einrichtung zum Einspritzen flüssiger Medizin nach einem der vorhergehenden Ansprüche, gekennzeichnet durch Mittel (30) zum Überwachen der verbleibenden Erzeugnis-Lebensdauer des Fluids, wobei die Überwachungsmittel ein Zeitglied, welches zum Starten des Zählens auf einen voreingestellten Wert nach dem Empfang eines Startsignals (H bei OPIN) eingerichtet sind, Mittel zum Zurücksetzen des Zeitgliedes auf einen Zwischenwert nach Betätigung eines Schalters (C), wobei der Zwischenwert den voreingestellten Wert minus einer ganzzahligen Größe umfaßt, welche die Zeit wiedergibt, die folgend auf den Empfang des Startsignals abgelaufen ist, sowie Mittel (BZ) zum Erzeugen einer Warnung in Antwort darauf, daß die Zeit den voreingestellten Wert erreicht, umfassen, um anzuzeigen, daß die verbleibende Erzeugnis-Lebensdauer des Fluids sich dem Ablauf nähert und/oder diesen erreicht hat.

**8.** Einrichtung zum Einspritzen flüssiger Medizin nach einem der vorhergehenden Ansprüche, dadurch gekennzeichnet, daß das Steuermittel Mittel zum Überwachen eines Erfassungspotentials an einem Anschluß ($V_{DE}$) zum Zuführen der Antriebsimpulse zu dem piezoelektrischen Element umfaßt, wobei die Überwachungsmittel Mittel zum Abtasten des Erfassungspotentials bei vorbestimmten Zeiten in einer Antriebsperiode, Mittel zum Vergleichen des abgetasteten Erfassungspotentials mit einer Referenz und Mittel (BZ) zum Erzeugen einer Warnung in Antwort auf eine Ausgabe von den Vergleichsmitteln umfassen.

**9.** Einrichtung zum Einspritzen flüssiger Medizin nach Anspruch 1, gekennzeichnet durch Mittel zum Zuführen von Taktimpulsen zum Steuern des Timings der Erzeugungsmittel und des Steuermittels, wobei das Steuermittel Mittel zum Überwachen der Frequenz der Taktimpulse umfassen, wobei die Zuführmittel erste und zweite Taktoszillationsfreuenz-Erzeugermittel (101, 102) umfassen und wobei die Überwachungsmittel erste und zweite Zählglieder (107, 108) umfassen, wobei das erste Zählglied (107) zum Zählen in Antwort auf die erste Taktoszillationsfrequenz und zum Zurücksetzen in Antwort auf die zweite Taktoszillationsfrequenz eingerichtet ist und wobei das zweite Zählglied (108) zum Zählen in Antwort auf die zweite Taktoszillationsfrequenz und zum Zurücksetzen in Antwort auf die erste Taktoszillationsfrequenz eingerichtet ist, und Frequenzteilermittel (103 bis 106) umfassen, welche zwischen den Taktoszillationsfrequenz-Erzeugermitteln und den Zählgliedern angeordnet sind, wobei die Anordnung derart ist, daß das erste Zählglied in Antwort auf eine Zunahme der ersten Taktoszillationsfrequenz der Taktimpulse oder eine Abnahme der zweiten Taktoszillationsfrequenz eine Ausgabe erzeugt und das zweite Zählglied in Antwort auf eine Abnahme der ersten Taktoszillationsfrequenz oder eine Zunahme der zweiten Taktoszillationsfrequenz eine Ausgabe erzeugt.

**10.** Einrichtung zum Einspritzen flüssiger Medizin nach Anspruch 1, dadurch gekennzeichnet, daß das Steuermittel eine Schaltung mit weichem Start eines Schaltreglers umfaßt zum Steuern der Erzeugung der Schaltimpulse mit einer verringerten Frequenz während einer vorbestimmten Periode folgend auf die Zufuhr eines Startsignals, wobei die Schaltung mit weichem Start ein Zeitglied (910), welches auf das Startsignal anspricht, um die vorbestimmte Periode einzustellen und um ein Anfangszustands-Auflösesignal nach dem Ablauf der vorbestimmten Periode zu erzeugen, eine Frequenzteilerschaltung (925) zum Teilen der Frequenz der Eingangstaktimpulse, und Gattermittel (930, 940) umfaßt, welche dazu eingerichtet sind, während der vorbestimmten Periode eine Ausgabe von der Frequenzteilschaltung zu den Mitteln zum Erzeugen der Antriebsimpulse zu liefern und in Antwort auf das Anfangszustands-Auflösesignal die Eingangstaktimpulse zu den Mitteln zum Erzeugen der Antriebsimpulse zu liefern.

**11.** Überwachungs-Steuerverfahren für eine Einrichtung zum Einspritzen flüssiger Medizin nach einem der vorhergehenden Ansprüche, gekennzeichnet durch die Schritte des Durchführens von wenigstens einer Abgabe-Demonstration zum Antreiben der Mikropumpe für eine vorgegebene Zeitperiode zum Abgeben von Flüssigkeit und/oder einer Alarm-Demonstration zum Erzeugen von Lebensdauervorhersage- und Lebensdauerablauf-Warnungsalarmen und/oder einer Betriebsbestätigungston-Demonstration zum Erzeugen eines Alarms mit einem gegebenen Tonmuster.

**Revendications**

**1.** Dispositif pour injecter un médicament liquide comprenant un système de commande pour micro-pompe, le système de commande ayant des moyens pour générer des impulsions d'entraînement à appliquer à un élément piézo-électrique (7) pour entraîner la pompe, et caractérisé par des moyens (200, 400) pour commander la distribution du fluide par la pompe en commandant sélectivement la génération des impulsions d'entraînement, les moyens de commande comprenant des moyens de réglage (31, 403, 405) répondant à des données d'impulsions d'entraînement introduites pour régler une valeur d'une caractéristique donnée de la période d'entraînement, et des moyens sélecteurs de niveau (30, 408) répondant à une entrée de commutation pour choisir entre des quantités fractionnaires de la caractéristique définie de manière à exercer une commande précise sur le débit distribué par la pompe.

2. Dispositif d'injection d'un médicament liquide selon la revendication 1, caractérisé en ce que la caractéristique donnée est constituée par le nombre des impulsions d'entraînement générées dans la période d'entraînement prédéterminée.

3. Dispositif d'injection d'un médicament liquide selon la revendication 1, caractérisé en ce que la caractéristique donnée est constituée par la fréquence des impulsions d'entraînement générées pendant la période d'entraînement prédéterminée.

4. Dispositif d'injection d'un médicament liquide selon l'une quelconque des revendications 1 à 3, caractérisé en ce que la caractéristique donnée est constituée par l'amplitude des impulsions d'entraînement générées pendant la période d'entraînement prédéterminée.

5. Dispositif d'injection d'un médicament liquide selon l'une quelconque des revendications précédentes, caractérisé en ce que les moyens de réglage comprennent des moyens de réglage de base (403) pour définir une valeur de base de la caractéristique donnée, et des moyens de réglage fin (405) pour corriger la valeur de base.

6. Dispositif d'injection d'un médicament liquide selon l'une quelconque des revendications précédentes, caractérisé en ce que les moyens sélecteurs de niveau comprennent un sélecteur (408) et des moyens d'application de la valeur définie directement au sélecteur et par l'intermédiaire d'au moins un multiplicateur par un coefficient (406, 407), respectivement.

7. Dispositif d'injection d'un médicament liquide selon l'une quelconque des revendications précédentes, caractérisé par des moyens (30) de surveillance de la durée d'utilisation restante du fluide, les moyens de surveillance comprenant une minuterie construite pour commencer à compter jusqu'à une valeur prédéterminée à la réception d'un signal de départ (H en OPIN), des moyens pour ramener la minuterie à une valeur intermédiaire au moment d'une manoeuvre d'un commutateur (C), la valeur intermédiaire étant constituée par la valeur prédéterminée moins une quantité entière représentant le temps qui s'est écoulé après la réception du signal de départ, et des moyens (BZ) pour générer un avertissement lorsque le temps atteint la valeur prédéterminée pour signaler que la durée restante du produit fluide est proche et/ou a atteint l'échéance.

8. Dispositif d'injection d'un médicament liquide selon l'une quelconque des revendications précédentes, caractérisé en ce que les moyens de commande comprennent des moyens pour surveiller la détection d'un potentiel sur une borne ($V_{DE}$) servant à appliquer les impulsions d'entraînement à l'élément piézo-électrique, les moyens de surveillance comprenant des moyens pour échantillonner le potentiel détecté à des instants prédéterminés d'une période d'entraînement, des moyens pour comparer le potentiel détecté échantillonné à une valeur de référence, et des moyens (BZ) pour générer un avertissement en réponse à une sortie des moyens comparateurs.

9. Dispositif d'injection d'un médicament liquide selon la revendication 1, caractérisé par des moyens pour appliquer des impulsions d'horloge destinées à commander la base de temps des moyens générateurs et des moyens de commande, les moyens de commande permettant la surveillance de la fréquence des impulsions d'horloge, les moyens d'application comprenant des premiers et des seconds moyens générateurs d'une fréquence d'oscillation d'horloge (101, 102) et les moyens de surveillance comprenant des premier et second compteurs (107, 108), le premier compteur (107) étant conçu pour compter en réponse à la première fréquence d'oscillation d'horloge et à être ramené à zéro en réponse à la seconde fréquence d'oscillation d'horloge, et le second compteur (108) étant conçu pour compter en réponse à la seconde fréquence d'oscillation d'horloge, et pour être ramené à zéro en réponse à la première fréquence d'oscillation d'horloge, et des moyens diviseurs de fréquence (103 à 106) montés entre les moyens générateurs de fréquence d'oscillation d'horloge et les compteurs, le montage étant tel que le premier compteur génère une sortie en réponse à une augmentation de la première fréquence d'oscillation d'horloge des impulsions d'horloge, ou à une diminution de la seconde fréquence d'oscillation d'horloge, et que le second compteur génère une sortie en réponse à une diminution de la première fréquence d'oscillation d'horloge ou à une augmentation de la seconde fréquence d'oscillation d'horloge.

10. Dispositif d'injection d'un médicament liquide selon la revendication 1, caractérisé en ce que les moyens de commande comprennent un circuit de démarrage programmable d'un régulateur de commutation pour commander la génération des impulsions de commutation à une fréquence réduite pendant une période prédéterminée, à la suite de l'application d'un signal de départ, le circuit de démarrage programmable comprenant une minuterie (910) répondant au signal de départ, pour chronométrer la période prédéterminée et établir un signal de suppression de l'état initial à l'expiration de la période prédéterminée, un circuit diviseur de fréquence (925) pour diviser la fréquence des impulsions d'horloge appliquées, et des moyens de porte (930, 940) construits pour appliquer pendant la période prédéterminée une sortie du circuit diviseur de fréquence aux moyens générateurs des impulsions d'entraînement et, en réponse au signal de suppression de l'état initial, pour appliquer des impulsions d'entrée d'horloge aux moyens générateurs d'impulsions d'entraînement.

11. Procédé de commande de surveillance d'un dispositif d'injection d'un médicament liquide selon l'une quelconque des revendications précédentes, caractérisé par les opérations consistant à effectuer au moins une démonstration de distribution pour entraîner ladite micro-pompe pendant une période de temps donnée, afin de distribuer un liquide, une démonstration d'alarme pour former les alarmes de prédiction de durée du produit, et d'avertissement d'expiration de durée, et une démonstration du fonctionnement du signal sonore d'accusé-réception pour délivrer une alarme ayant une configuration sonore donnée.

## FIG._1

TANK *210*

MICROPUMP *10*

*208*

CONTROL CIRCUIT

*222*

*221*

*206*

DISPLAY UNIT

CONTROL APPARATUS

*200*

## FIG._3

| SWITCH | MODE - 0 , MODE - 3 | MODE - 1 | MODE - 2 |
|--------|---------------------|----------|----------|
| A | INEFFECTIVE | PULSE CHECK | INEFFECTIVE |
| B | INEFFECTIVE | ALARM TEST HEARING | INEFFECTIVE |
| C | INEFFECTIVE | GENERATION OF PIEZOELECTRIC ELEMENT DRIVING PULSES ON/OFF | |
| D | INEFFECTIVE | STOP SOUNDING OF OPERATION ACKNOWLEDGE AND ALARM AL$_1$ | |
| E | INEFFECTIVE | SELECTION OF PIEZOELECTRIC ELEMENT DRIVING PULSE OUTPUT PATTERN | |

FIG._2

EP 0 439 327 B1

FIG. 4

1/8

**FIG._5**

2 SECONDS

1/8

**FIG._6**

1 SECOND

(INITIAL DISPLAY)

(DISPLAY DURING DISCHARGE DEMONSTRATION)

SEL 1

S

7D

SWITCH A

SEL 1

7D

**FIG._7**

ACKNOWLEDGE SOUND UPON COMPLETION OF OUTPUT

(DISPLAY DURING AL DEMONSTRATION)

SEL 1

7D

(INITIAL DISPLAY)

SEL 1

S

7D

SWITCH B

SWITCH B

(DISPLAY DURING AL DEMONSTRATION)

S

**FIG._8**

FIG.__9

SEL 1

S

7D

SWITCH A → PRODUCTION OF OPERATION ACKNOWLEDGE SOUND

FIG.__10

1/8

1 SECOND

FIG.__11

1 SEC 1 Hz

PRESET NUMBER OF PULSES

3 MINUTES

SEL 1

YD

MODE 1 START

7 6 5 4 3 2 1 0

AL1 AL2

MODE 2 (X = 0.8)

7 6 5 4 3 2 1 0

AL1 AL2

MODE 2 (X = 3.2)

4 3 2 1 0

AL1 AL2

MODE 2 (X = 7.3)

0

AL1 AL2

FIG.__12

1/8  f = 4096 Hz

**FIG._13**

2 SECONDS

1/8  f = 4096 Hz

**FIG._14**

2 SECONDS

AIR IS
INTRODUCED
(1,1,1)

H

THRESHOLD

L

NORMAL
CONDITION
(0,1,1)

DETECTING
PIEZOELECTRIC
ELEMENT
DISPLACEMENT

CLOGGED
CONDITION
(0,0,0)

0       10         30         50    MSEC
       (T1)        (T2)       (T3)

EP 0 439 327 B1

FIG._16

SUCTION          DISCHARGE

FIG._18A

FIG._18B

FIG._17

FIG._19

FIG._20

FIG._21A  CLOCK SIGNALS

FIG._21B  TRIGGER SIGNALS

FIG._21C  LOW - NUMBER SIGNALS

COMMANDED NUMBER OF PULSES

FIG._21D  MEDIUM - NUMBER SIGNALS

$k_1 \times N$

FIG._21E  HIGH - NUMBER SIGNALS

$k_2 \times N$

TIME

EP 0 439 327 B1

FIG._22

EP 0 439 327 B1

LOW - FREQUENCY
PULSES

# FIG._23A

TIME ⟶

INTERMEDIATE -
FREQUENCY
PULSES

# FIG._23B

TIME ⟶

HIGH - FREQUENCY
PULSES

# FIG._23C

TIME ⟶

318

314

320

321

110

316

324

TIME ⟶

# FIG._28

FIG._24

FIG._26

EP 0 439 327 B1

LOW - VOLTAGE
PULSES

30V

TIME ——→

*FIG._25A*

MEDIUM -
VOLTAGE
PULSES

50V

TIME ——→

*FIG._25B*

HIGH -
VOLTAGE
PULSES

100V

TIME ——→

*FIG._25C*

#1    #2              #34    #35

#1 EXAMPLE OF
-COMBINED
PULSES

50V        #36  30V

TIME ——→

*FIG._25D*

#1    #2              #34    #35

#2 EXAMPLE OF
COMBINED
PULSES

50V    70V

TIME ——→

*FIG._25E*

FIG.\_27

318

314

320

321

110

116

324

TIME ————▶

## FIG.__29

316

322

323

111

315

324

TIME ————▶

## FIG.__30

FIG._31

FIG._32

EP 0 439 327 B1

FIG._33

A2D 714
A2D1 719
A2D2 720
φ256 713
f2D 718
φ64 711
f1D1 716
f1D2 717
322
323
865
867
868
870
CPUS 851
B4 852

TIME →

EP 0 439 327 B1

FIG._34

EP 0 439 327 B1

FIG._35

EP 0 439 327 B1

951

952

953

954

START

*FIG._36*

TIME ⟶

EP 0 439 327 B1

961

954

963

*FIG._38*

TIME ⟶

FIG._37